Europäisches Patentamt

European Patent Office

Office européen des brevets

(19)

(11)  EP 1 237 166 A2

(12)  **EUROPEAN PATENT APPLICATION**

(43) Date of publication:
   **04.09.2002  Bulletin 2002/36**

(51) Int Cl.⁷: **H01G 9/20**, H01L 31/0236

(21) Application number: **02004524.1**

(22) Date of filing: **27.02.2002**

(84) Designated Contracting States:
   **AT BE CH CY DE DK ES FI FR GB GR IE IT LI LU MC NL PT SE TR**
   Designated Extension States:
   **AL LT LV MK RO SI**

(30) Priority: **28.02.2001  JP  2001055110**

(71) Applicants:
   • **Kabushiki Kaisha Toyota Chuo Kenkyusho**
     **Aichi-gun, Aichi-ken, 480-1192 (JP)**
   • **Aisin Seiki Kabushiki Kaisha**
     **Kariya-shi, Aichi-ken 448-6850 (JP)**

(72) Inventors:
   • **Motohiro, Tomoyoshi,**
     **K.K. Toyota Chuo Kenkyusho**
     **Aichi-gun, Aichi 480-1192 (JP)**
   • **Higuchi, Kazuo, K.K. Toyota Chuo Kenkyusho**
     **Aichi-gun, Aichi 480-1192 (JP)**

   • **Azuma, Hirozumi, K.K. Toyota Chuo Kenkyusho**
     **Aichi-gun, Aichi 480-1192 (JP)**
   • **Takeda, Yasuhiro, K.K. Toyota Chuo Kenkyusho**
     **Aichi-gun, Aichi 480-1192 (JP)**
   • **Inaba, Tadashi, K.K. Toyota Chuo Kenkyusho**
     **Aichi-gun, Aichi 480-1192 (JP)**
   • **Tsukigase, Azusa, K.K. Toyota Chuo Kenkyusho**
     **Aichi-gun, Aichi 480-1192 (JP)**
   • **Doi, Shoichi**
     **Kariya-shi, Aichi 448-0038 (JP)**
   • **Nishimura, Kazuhiko**
     **Takahama-shi, Aichi 444-1332 (JP)**
   • **Toyoda, Tatsuo**
     **Nagoya-shi, Aichi 465-0091 (JP)**

(74) Representative:
   **Blumbach, Kramer & Partner GbR**
   **Radeckestrasse 43**
   **81245 München (DE)**

(54)  **Dye-sensitized solar cells and dye-sensitized solar cell modules**

(57)   A dye-sensitized solar cell 10 is a dye-sensitized solar cell which comprises a photo-electrode WE having a semiconductor electrode 2 and a transparent electrode 1 placed on a photoreceptive surface F2 of the semiconductor electrode 2; and a counter electrode CE and in which the semiconductor electrode is opposed through an electrolyte E to the counter electrode, wherein the photoreceptive surface of the semiconductor electrode is formed so that an angle θ of incidence of light incident to the photoreceptive surface of the semiconductor electrode from a direction of a normal to a photoreceptive surface F1 of the transparent electrode falls within a range of 30 to 80°.

Fig.1

EP 1 237 166 A2

**Description**

BACKGROUND OF THE INVENTION

Field of the Invention

The present invention relates to dye-sensitized solar cells and dye-sensitized solar cell modules.

Related Background Art

In recent years, various development projects of solar cells are being pursued with growing concern about the global warming and energy problems. In order to implement practical use of dye-sensitized solar cells among such solar cells, it is necessary to enhance the energy conversion efficiency (photoelectric conversion efficiency) thereof at least up to the level equivalent to those of amorphous silicon solar cells.

For example, a dye-sensitized solar cell module having the size of approximately 1 m $\times$ 1 m is required to achieve the energy conversion efficiency of not less than about 8%. For that reason, each of the dye-sensitized solar cells (hereinafter referred to simply as "cells"), which are constitutive units of the dye-sensitized solar cell module on that scale, is required to achieve the energy conversion efficiency over about 8% in consideration of loss of the photoreceptive area due to frame portions formed between the cells for mutual coupling of the cells and loss of the photoreceptive area due to comb-shaped electrodes provided for increase of current collection efficiency. For example, where a module having the aforementioned value of energy conversion efficiency is constructed of cells having the size of approximately 10 cm $\times$ 10 cm, each cell is required to achieve the energy conversion efficiency of not less than about 10%.

The energy conversion efficiency of the dye-sensitized solar cells is expressed by Eq (1) below, using the intensity $I_0$ of incident light [mWcm$^{-2}$], open-circuit voltage $V_{oc}$ [V], short-circuit current density $I_{sc}$ [mAcm$^{-2}$], and fill factor F.F.

$$\text{Energy conversion efficiency} = (V_{oc} \times I_{sc} \times \text{F.F.})/I_0 \qquad (1)$$

As apparent from Eq (1) above, the energy conversion efficiency can be enhanced by increasing $V_{oc}$, $I_{sc}$, and F.F., but it is not easy to increase them. Therefore, various attempts have been made to enhance the energy conversion efficiency by increasing the utilization factor (quantum efficiency) of the incident light in the semiconductor electrode.

For example, the incident light harvest efficiency can be enhanced by increasing the thickness of the semiconductor electrode containing a dye to lengthen optical paths of the incident light. However, the increase in the thickness of the semiconductor electrode results in increasing the electric resistance of the semiconductor electrode, increasing the carrier extinction amount in the electrode, and increasing the ion diffusion resistance in the electrolyte present in nanopores in the electrode, which will lower the energy conversion efficiency on the contrary. Thus, attempts are being made to enhance the incident light harvest efficiency in the semiconductor electrode under the small thickness condition of the semiconductor electrode (not more than 15 µm).

For example, there are the dye-sensitized solar cells proposed for the purpose of enhancing the utilization factor by making semiconductor particles with large particle sizes and semiconductor particles with small particle sizes mixed in the semiconductor electrode and scattering the incident light entering the semiconductor electrode therein. Japanese Patent No. 2664194 suggests the dye-sensitized solar cell capable of achieving the energy conversion efficiency value as high as about 12% by such a configuration that the semiconductor electrode is made of apolycrystalline metal oxide semiconductor and in the thickness of about 20 µm, the surface of the, semiconductor electrode has the roughness factor over 20, and the surface contains the dye.

SUMMARY OF THE INVENTION

In the conventional dye-sensitized solar cells the semiconductor electrode of which contains the mixture of semiconductor particles with large particle sizes and semiconductor particles with small particle sizes, however, the optical scattering caused by the large semiconductor crystal particles results in lengthening optical paths for passage in the semiconductor electrode and thus increasing the utilization factor of light, as compared with the cells without the large semiconductor particles. Since the conventional dye-sensitized solar cells utilized the scattering phenomenon to the last, they had a problem that part of light passed through the semiconductor electrode. Increase of large semiconductor crystal particles posed another problem that the total surface area of semiconductor surfaces, to which the dye adsorbed, decreased to reduce optical absorptance and, in turn, lower the photoelectric conversion efficiency.

The dye-sensitized solar cell described in Japanese Patent No. 2664194 is not provided with separate collecting wires on a transparent, conductive film, and thus electrons injected from the dye excited based on absorption of light, into the metal oxide semiconductor are collected only by the transparent, conductive film to be extracted as electric power. However, when the area of the cell is greater than 1 cm × 1 cm, the limit of electrical conduction of the transparent, conductive film increases the resistance loss and decreases the shape factor, thereby decreasing the conversion efficiency. Accordingly, when the area of the cell is greater than 1 cm × 1 cm, it is necessary to provide collecting wires of Ag or the like at fixed intervals to decrease the resistance loss. In this case, however, there arises a new problem of corrosion of the collecting wires by the electrolyte, and it is thus necessary to provide a protective layer for protection of the collecting wires and also change the electrolyte to a component composition hardly corroding the collecting electrodes. The placement of such collecting electrodes and protective layer decreases the effective area to photoelectric conversion of the cell. The change of the electrolyte composition leads to decrease in the conversion efficiency under the current state of the art.

Further, when a solar cell panel having a larger area is constructed by combining a plurality of solar cells having the area of 10 cm × 10 cm, wire leading-out and outer packaging issues necessitate the frame portions, not contributing to photoelectric conversion, for each of the solar cells arranged adjacent to each other and each having the area of 10 cm × 10 cm, so that the effective area for photoelectric conversion further decreases. Further, when a solar cell module is comprised of a combination of a plurality of such solar cell panels, the frame portions are also formed between the solar cell panels, so as to further increase the loss of the effective area for photoelectric conversion. Under such circumstances, there was the problem that it was very difficult for the dye-sensitized solar cells to achieve the conversion efficiency of the practical use level even through the use of the technology described in Japanese Patent No. 2664194.

The present invention has been accomplished in view of the problems of the prior art and an object of the invention is to provide dye-sensitized solar cells and dye-sensitized solar cell modules having excellent energy conversion efficiencies of practical use level and being capable of generating electric power on a stable basis.

The inventors performed elaborate research in order to accomplish the above object and found that, while it was common recognition of those skilled in the art that the energy conversion efficiency was effectively enhanced by incidence of light to the semiconductor electrode from the direction of the normal to the electrode surface (photoreceptive surface) (which will be referred to hereinafter as "normal incidence"), the dye-sensitized solar cells were able to demonstrate higher utilization factors of incident light and thus increase electric power generated per unit effective area, as compared with the normal incidence cells, when the light was made incident at angles of incidence in the range of 30 to 80° relative to the direction of the normal to the electrode surface (which will be referred to hereinafter as "oblique incidence").

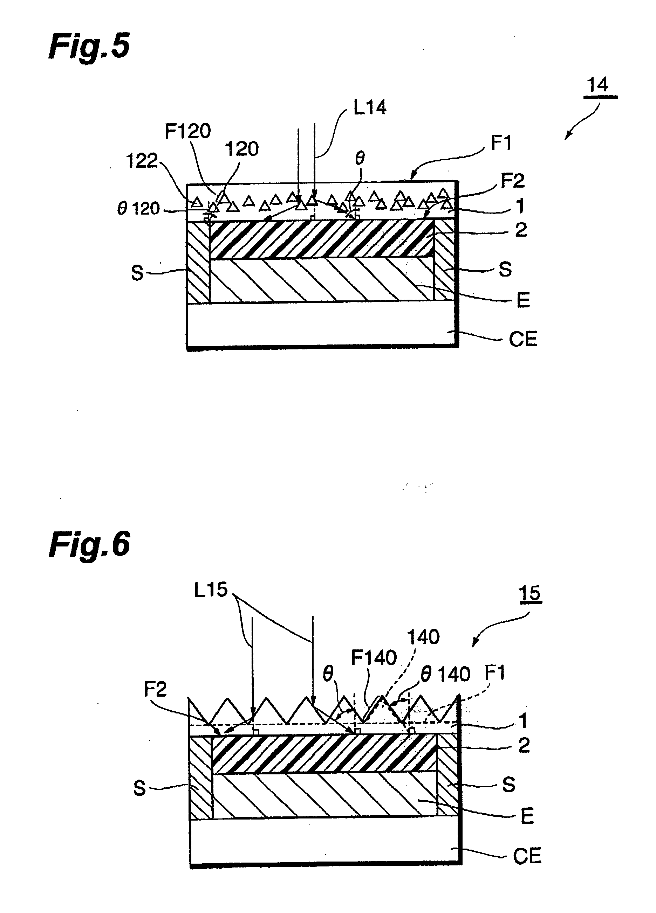

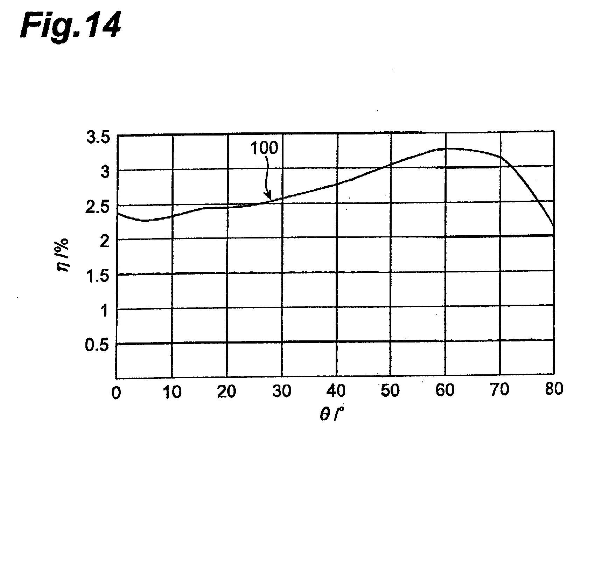

For example, the light incidence angle dependence of energy conversion efficiency was measured with a dye-sensitized solar cell 100 (which has the structure similar to the dye-sensitized solar cell UC shown in Fig. 6), which had a photo-electrode in structure wherein a $TiO_2$ semiconductor electrode having the 50 $mm^2$ area of a portion contributing to power generation in the photoreceptive surface and the thickness of 20 $\mu$m was formed on a glass substrate having the thickness of 1.1 mm; an electrolyte consisting of an iodine base redox solution; and a counter electrode CE in structure wherein a thin film of Pt (film thickness; 3nm) was deposited on a fluorine-doped $SnO_2$ coated glass substrate having the shape and size similar to those of the foregoing glass substrate, and the results obtained are presented in the graph of Fig. 14. "$\eta$" on the ordinate in Fig. 14 represents "effective energy conversion efficiency" described hereinafter. As apparent from the results presented in Fig. 14, it was verified that the energy conversion efficiency was enhanced by oblique incidence of light at angles of incidence in the range of 30 to 80° relative to the direction of the normal to the electrode surface.

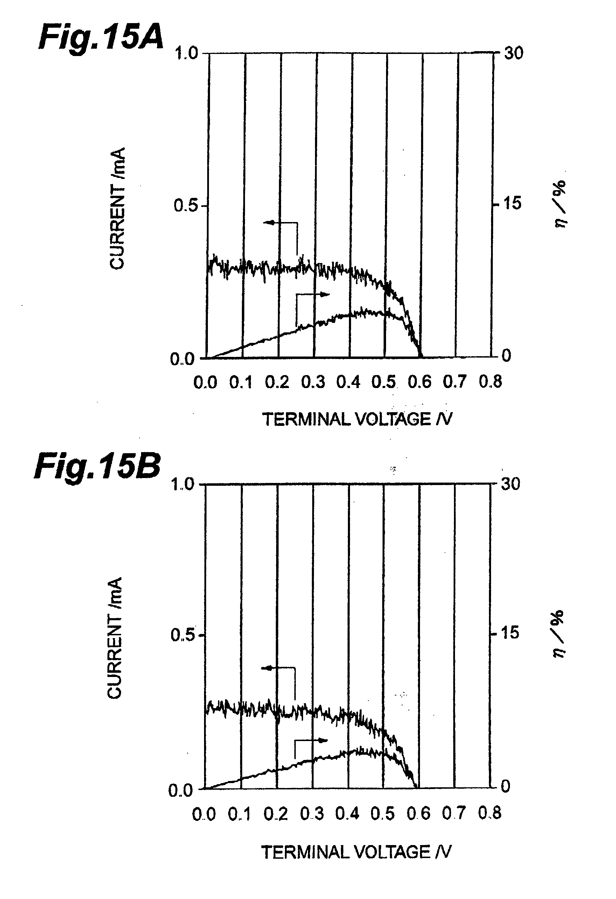

Further, with this dye-sensitized solar cell 100, the current-voltage (I-V) characteristics and $\eta$ were measured in the case of light incidence at the angle of incidence of about 45° and in the case of light incidence from the normal direction, and the results are presented in Fig. 15 (a) and (b). Fig. 15 (a) is a graph to show the current-voltage characteristics and energy conversion efficiency in the case where the light was made incident at the incidence angle of about 45° relative to the direction of the normal to the electrode surface of the dye-sensitized solar cell 100, and Fig. 15 (b) a graph to show the current-voltage characteristics and energy conversion efficiency in the case where the light was made incident from the direction of the normal to the electrode surface of the dye-sensitized solar cell 100. The measurement conditions herein were that irradiation intensity; 4.2 $mW/cm^2$ and measurement temperature; 27.8°C on the photoreceptive surface of the semiconductor electrode in the both cases of the measurement of the cell characteristics in Fig. 15 (a) and the measurement of the cell characteristics in Fig. 15 (b). In the case of the measurement of the cell characteristics in Fig. 15 (a), the resultant maximum energy conversion efficiency was 4.3140% (short-circuit current $I_{sc}$; 0.3030 mA, open-circuit voltage Voc; 0.6024 V, fill factor F.F.; 0.7289). On the other hand, in the case of the measurement of the cell characteristics in Fig. 15 (b), the resultant maximum energy conversion efficiency was 3.7080% (short-circuit current $I_{sc}$; 0.2427 mA, open-circuit voltage Voc; 0.5880 V, fill factor F.F.; 0.8875).

Then the inventors found that the above was extremely effective in enhancing the energy conversion efficiency of the dye-sensitized solar cells anddye-sensitized solar cell modules, thus accomplishing the present invention.

Namely, a dye-sensitized solar cell of the present invention is a dye-sensitized solar cell which comprises a photo-electrode having a semiconductor electrode and a transparent electrode placed on a photoreceptive surface of the semiconductor electrode, and a counter electrode and in which the semiconductor electrode is opposed through an electrolyte to the counter electrode, wherein the photoreceptive surface of the semiconductor electrode is formed so that an angle of incidence of light incident to the photoreceptive surface of the semiconductor electrode from a direction of a normal to a photoreceptive surface of the transparent electrode falls within a range of 30 to 80°.

By employing this configuration wherein a reference is defined along the traveling direction of the light incident from the direction of the normal to the photoreceptive surface of the transparent electrode and wherein the photoreceptive surface of the semiconductor electrode is inclined relative to the photoreceptive surface of the transparent electrode so as to make the light obliquely incident to the electrode surface of the semiconductor electrode, it becomes feasible to secure sufficiently long optical paths in the semiconductor electrode even under the small thickness condition of the semiconductor electrode.

Namely, the sufficiently long optical paths can be secured in the semiconductor electrode without loss of the advantages that (1) optical excitation of the dye in the semiconductor electrode and injection of electrons into the semiconductor can be efficiently effected in the region near the transparent electrode with low electric resistance and low carrier loss and that (2) dye reduction, reaction in which redox species of $I^-/I_3^-$ or the like act on the dye as having optically been excited and injected electrons into the semiconductor, can be efficiently brought about in the region near the electrolyte with small ion diffusion resistance, in the case of the small thickness of the semiconductor electrode; it is, therefore, feasible to enhance the incident light harvest efficiency and, in turn, to enhance the energy conversion efficiency per unit effective area of the semiconductor electrode.

Specifically, the dye-sensitized solar cell of the present invention employing the oblique incidence is able to achieve the improvement of 5 to 50% in the energy conversion efficiency per unit effective area of the semiconductor electrode, as compared with the conventional dye-sensitized solar cells employing the normal incidence.

The above result is the feature of the dye-sensitized solar cell, which cannot be achieved when the light is made obliquely incident to the ordinary, solid-state pn junction solar cells such as Si solar cells and the like.

The "effective area of the semiconductor electrode" in the present invention refers to an area represented by $S_0\cos\theta$, where $S_0$ is an actual area of the photoreceptive surface of the semiconductor electrode and $\theta$ is an angle of incidence of light incident to the photoreceptive surface of the semiconductor electrode from the direction of the normal to the photoreceptive surface of the transparent electrode. Namely, when the photoreceptive surface of the semiconductor electrode is inclined at an inclination angle $\theta$ relative to the photoreceptive surface of the transparent electrode or the installation surface where the dye-sensitized solar cell is installed, the effective area of the semiconductor electrode represents an area of an orthogonal projection of the actual area $S_0$. In the present invention, the "energy conversion efficiency per unit effective area of the semiconductor electrode" will be referred to hereinafter as "effective energy conversion efficiency" in the following description.

When the angle of incidence of the light incident to the photoreceptive surface of the semiconductor electrode is less than 30° relative to the direction of the normal to the photoreceptive surface of the transparent electrode, the merit by the oblique incidence of light is little and is canceled out by decrease in energy of light per unit area from that in the case of the normal incidence of the incident light to the photoreceptive surface, and there is thus little hope for enhancement of "effective energy conversion efficiency." When the angle of incidence of the light incident to the photoreceptive surface of the semiconductor electrode exceeds 80° relative to the direction of the normal to the photoreceptive surface of the transparent electrode on the other hand, there is little hope for enhancement of "effective energy conversion efficiency" for two reasons below. Namely, the first reason is that when the photoreceptive surface of the transparent electrode is parallel to the photoreceptive surface of the semiconductor electrode, reflection becomes noticeable on the surface of the transparent electrode at incident angles over 80° and the light becomes hard to arrive at the semiconductor electrode. The other reason is that when the light is incident normally to the transparent electrode and incident at the incident angles over 80° to the semiconductor electrode, the reflection loss and scattering loss increase at the interface between the transparent electrode and the semiconductor electrode. From much the same viewpoints as above, the angle of incidence of the light incident to the photoreceptive surface of the semiconductor electrode from the direction of the normal to the photoreceptive surface of the transparent electrode is more preferably in the range of 40 to 75° and still more preferably in the range of 50 to 70°.

Further, the thickness of the semiconductor electrode in the dye-sensitized solar cell of the present invention is preferably in the range of 5 to 30 μm, more preferably in the range of 5 to 15 μm, and still more preferably in the range of 8 to 13 μm. When the thickness of the semiconductor electrode is less than 5 μm, the dye adsorption amount is small and the semiconductor electrode increases a tendency of failing to effectively absorb the light. When the thickness of the semiconductor electrode exceeds 30 μm on the other hand, the electric resistance increases to increase the amount of loss of carriers injected into the semiconductor, and the ion diffusion resistance also increases, so that injection of electrons from I$^-$ into the dye as having optically been excited and injected electrons into the semiconductor hinders transport of I$_3^-$ to the counter electrode, thereby increasing a tendency of degrading the output characteristics of the cell.

Another dye-sensitized solar cell of the present invention is a dye-sensitized solar cell which comprises a photo-electrode having a semiconductor electrode and a transparent electrode placed on a photoreceptive surface of the semiconductor electrode, and a counter electrode and in which the semiconductor electrode is opposed through an electrolyte to the counter electrode, wherein the transparent electrode is provided with lightguide means for changing a traveling direction of light incident from the outside to the photoreceptive surface of the transparent electrode so that an angle of incidence of the light traveling in the transparent electrode to enter the photoreceptive surface of the semiconductor electrode falls within a range of 30 to 80°.

By employing this configuration wherein the lightguide means for changing the traveling direction of the light incident from the outside of the cell to the photoreceptive surface of the transparent electrode is provided in the upper part of the transparent electrode whereby the light incident normally to the photoreceptive surface of the transparent electrode is made obliquely incident to the photoreceptive surface of the semiconductor electrode, it becomes feasible to secure sufficiently long optical paths in the semiconductor electrode even under the small thickness condition of the semiconductor electrode, as in the case of the dye-sensitized solar cell described previously. For that reason, it becomes feasible to enhance the incident light harvest efficiency and, in turn, enhance the effective energy conversion efficiency.

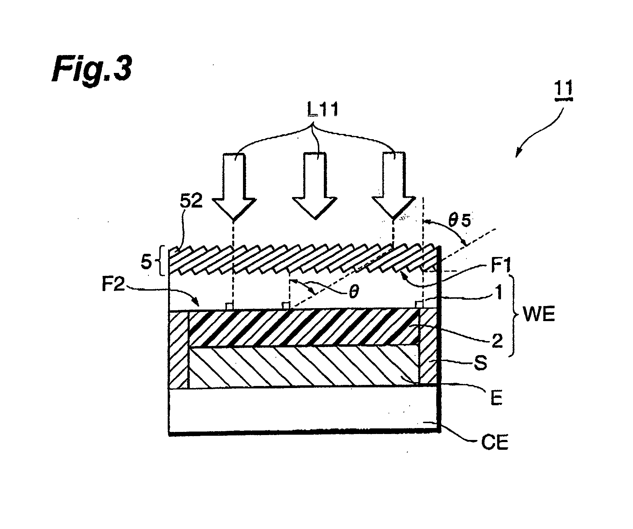

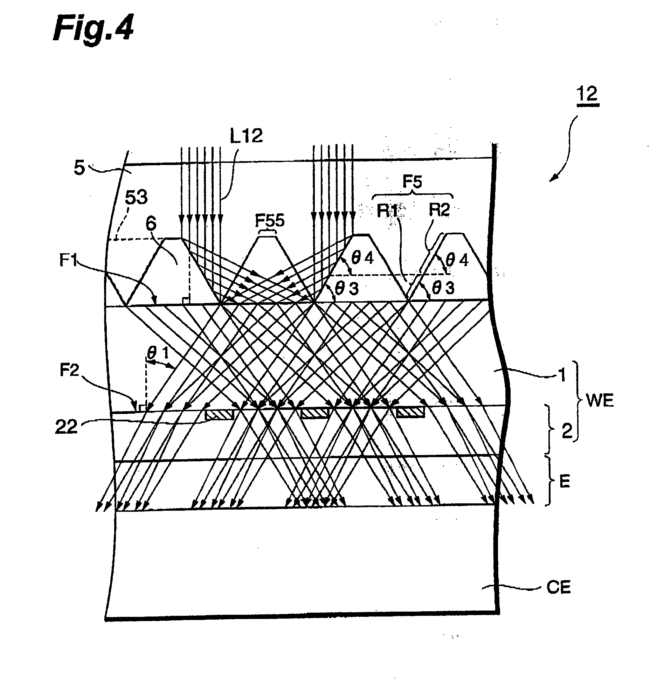

In the dye-sensitized solar cell of the present invention, which has the structure comprising the lightguide means as described above, the "traveling direction of the light incident from the outside to thephotoreceptive surface of the transparent electrode," which is a reference for formation of the photoreceptive surface of the transparent electrode or the photoreceptive surface of the semiconductor electrode, indicates the direction of the normal to the photoreceptive surface of the transparent electrode (e.g., cf. a surface F1 and a surface F2 shown in Fig. 4 described hereinafter) when the photoreceptive surface of the transparent electrode is flat. On the other hand, when the photoreceptive surface of the transparent electrode is not flat but the photoreceptive surface of the semiconductor electrode is flat, the "traveling direction" indicates the direction of the normal to the photoreceptive surface of the semiconductor electrode (e.g., cf. a surface F1 and a surface F2 shown in Fig. 3 described hereinafter). Further, whenneither of the photoreceptive surface of the transparent electrode and the photoreceptive surface of the semiconductor electrode is flat, a flat, virtual plane is set as a virtual, photoreceptive surface inside the transparent electrode or the semiconductor electrode, the traveling direction of the light incident from the outside is defined along a direction of a normal to the virtual, photoreceptive surface, and the actual photoreceptive surface of the transparent electrode or photoreceptive surface of the semiconductor electrode is designed on the basis of the reference of the traveling direction.

Further, in this case, it becomes feasible to control the angle of incidence of the light incident from the lightguide means to the electrode surface of the semiconductor electrode more precisely and readily. As a result, where a plurality of collecting electrodes (comb-shaped electrodes) are located inside the semiconductor electrode, the traveling direction of the incident light entering the semiconductor electrode can be controlled so as to avoid the collecting electrodes, whereby test cells on the laboratory level scale can be readily scaled up to cells on the practical use scale, without causing decrease of the effective energy conversion efficiency due to the collecting electrodes (comb-shaped electrodes).

However, when the dye-sensitized solar cell of the present invention has the structure provided with the lightguide means as described above and when the photoreceptive surface of the semiconductor electrode is flat, the aforementioned "effective area of the semiconductor electrode" is equal to the actual area $S_0$. Accordingly, in the present invention, the "effective energy conversion efficiency" in the case of the solar cells in such structure is the energy conversion efficiency per $S_0$, instead of $S_0\cos\theta$.

In the case as described above, the angle of incidence of the light incident to the photoreceptive surface of the semiconductor electrode from the direction of the normal to the photoreceptive surface of the transparent electrode or from the direction of the normal to the photoreceptive surface of the semiconductor electrode is also more preferably in the range of 40 to 75° and still more preferably in the range of 50 to 70°. In this case, the thickness of the semiconductor electrode is also preferably in the range of 5 to 30 μm, more preferably in the range of 5 to 15 μm, and still more preferably in the range of 8 to 13 μm.

Another dye-sensitized solar cell of the present invention is a dye-sensitized solar cell which comprises a photo-electrode having a semiconductor electrode and a transparent electrode placed on a photoreceptive surface of the semiconductor electrode, and a counter electrode and in which the semiconductor electrode is opposed through an electrolyte to the counter electrode, wherein a plurality of collecting electrodes are provided on the photoreceptive surface of the semiconductor electrode, wherein the photoreceptive surface of the semiconductor electrode is formed so that an angle of incidence of light traveling in the transparent electrode to enter the photoreceptive surface of the semiconductor electrode falls within a range of 30 to 80°, and wherein a photoreceptive surface of the transparent electrode is formed so that the light selectively impinges on areas without the collecting electrodes on the photoreceptive surface of the semiconductor electrode.

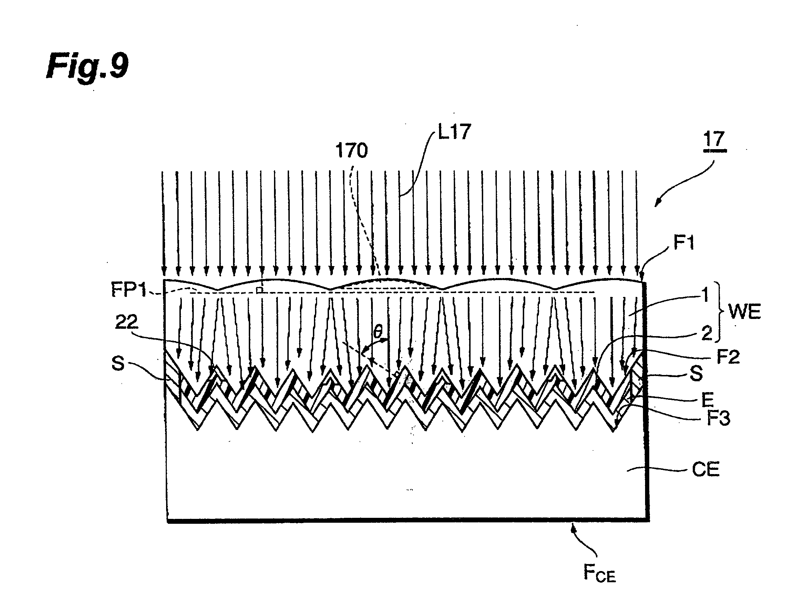

In the above-stated dye-sensitized solar cell, the "traveling direction of the light incident from the outside to the photoreceptive surface of the transparent electrode," which is the reference for formation of the photoreceptive surface of the transparent electrode or the photoreceptive surface of the semiconductor electrode, also indicates the direction of the normal to the photoreceptive surface of the transparent electrode when the photoreceptive surface of the transparent electrode is flat. On the other hand, when the photoreceptive surface of the transparent electrode is not flat but the photoreceptive surface of the semiconductor electrode is flat, the "traveling direction" indicates the direction of the normal to the photoreceptive surface of the semiconductor electrode. Further, when neither of the photoreceptive surface of the transparent electrode and the photoreceptive surface of the semiconductor electrode is flat, a flat, virtual plane is set as a virtual, photoreceptive surface inside the transparent electrode or the semiconductor electrode, the traveling direction of the light incident from the outside is defined along a direction of a normal to the virtual, photoreceptive surface, and the actual photoreceptive surface of the transparent electrode or photoreceptive surface of the semiconductor electrode is designed on the basis of the reference of the traveling direction (cf. a virtual, photoreceptive surface FP1 shown in Fig. 9 described hereinafter).

By forming the photoreceptive surface of the semiconductor electrode and the photoreceptive surface of the transparent electrode so as to satisfy the above condition, it becomes feasible to control the angle of incidence of the light incident to the electrode surface of the semiconductor electrode more precisely and readily. As a result, even if a plurality of collecting electrodes (comb-shaped electrodes) are placed inside the semiconductor electrode, the traveling direction of the incident light entering the semiconductor electrode can be controlled so as to avoid the collecting electrodes, whereby the test cells on the laboratory level scale can be readily scaled up to the cells on the practical use scale, without causing decrease of the effective energy conversion efficiency due to the collecting electrodes (comb-shaped electrodes).

In the case as described above, the angle of incidence of the light incident to the photoreceptive surface of the semiconductor electrode is also more preferably in the range of 40 to 75° and still more preferably in the range of 50 to 70°. In this case, the thickness of the semiconductor electrode is also preferably in the range of 5 to 30 $\mu$m, more preferably in the range of 5 to 15 $\mu$m, and still more preferably in the range of 8 to 13 $\mu$m.

Further, a dye-sensitized solar cell module of the present invention is a dye-sensitized solar cell module comprising a plurality of dye-sensitized solar cells placed on a base, each dye-sensitized solar cell comprising a photo-electrode having a semiconductor electrode and a transparent electrode placed on a photoreceptive surface of the semiconductor electrode, and a counter electrode and in each dye-sensitized solar cell the semiconductor electrode being opposed through an electrolyte to the counter electrode, wherein each dye-sensitized solar cell is placed so that an angle of incidence of light incident to each dye-sensitized solar cell from a direction of a normal to an installation surface of the base falls within a range of 30 to 80°.

By employing this configuration wherein a reference is defined along the traveling direction of the light incident to each dye-sensitized solar cell composing the module, from the direction of the normal to the installation surface of the base and wherein each dye-sensitized solar cell is inclined so as to make the light obliquely incident to the electrode surface of the semiconductor electrode in each cell, it becomes feasible to secure sufficiently long optical paths in the semiconductor electrode even under the small thickness condition of the semiconductor electrode, as in the case of the dye-sensitized solar cells described previously. For this reason, it becomes feasible to enhance the incident light harvest efficiency in each dye-sensitized solar cell and, in turn, enhance the energy conversion efficiency of the entire module. In this case, since the dye-sensitized solar cells can be fabricated and used in stable structure, it becomes feasible for the entire module to generate electric power at a high effective energy conversion efficiency on a stable basis.

Further, in this case, the light reflected on the photoreceptive surface of the semiconductor electrode in one dye-sensitized solar cell can be made obliquely incident to the photoreceptive surface of the semiconductor electrode in another dye-sensitized solar cell, whereby a significant antireflection effect can be achieved as the entire module.

In this case, the angle of incidence of the light incident to each dye-sensitizedsolar cell from the direction of the normal to the installation surface of the base is also more preferably in the range of 40 to 75° and still more preferably in the range of 50 to 70°. The thickness of the semiconductor electrode is also preferably in the range of 5 to 30 $\mu$m, more preferably in the range of 5 to 15 $\mu$m, and still more preferably in the range of 8 to 13 $\mu$m.

BRIEF DESCRIPTION OF THE DRAWINGS

Fig. 1 is a schematic, sectional view showing the first embodiment of the dye-sensitized solar cell according to the present invention.

Fig. 2 is a process diagram showing an example of a step of producing the photo-electrode in the dye-sensitized solar cell of Fig. 1.

Fig. 3 is a schematic, sectional view showing the second embodiment of the dye-sensitized solar cell according to the present invention.

Fig. 4 is a schematic, sectional view showing the third embodiment of the dye-sensitized solar cell according to the present invention.

Fig. 5 is a schematic, sectional view showing the fourth embodiment of the dye-sensitized solar cell according to the present invention.

Fig. 6 is a schematic, sectional view showing the fifth embodiment of the dye-sensitized solar cell according to the present invention.

Fig. 7 is a schematic, sectional view showing the sixth embodiment of the dye-sensitized solar cell according to the present invention.

Fig. 8 is a schematic, enlarged, sectional view of a portion of region R shown in Fig. 7.

Fig. 9 is a schematic, sectional view showing the seventh embodiment of the dye-sensitized solar cell according to the present invention.

Fig. 10 is a schematic, sectional view showing a preferred embodiment of the dye-sensitized solar cell module according to the present invention.

Fig. 11 is a schematic, sectional view of a dye-sensitized solar cell forming the dye-sensitized solar cell module shown in Fig. 10.

Fig. 12A is a sectional view showing another embodiment of the coat layer provided in the dye-sensitized solar cell shown in Fig. 4, 12B a front view of the coat layer shown in 12A, on the photo-electrode side, and 12C an enlarged view of a partial region PR1 of the coat layer shown in 12A.

Fig. 13A is a sectional view showing the result of ray tracing where normal incident light was made incident to the coat layer shown in Fig. 12, and 13B an enlarged view of a partial region PR2 of the coat layer shown in 13A.

Fig. 14 is a graph showing light incidence angle dependence of energy conversion efficiency of the dye-sensitized solar cell.

Fig. 15A is a graph showing the I-V characteristics and energy conversion efficiencies obtained when light was made incident at the angle of incidence of about 45° relative to the direction of the normal to the electrode surface of the dye-sensitized solar cell shown in Fig. 14, and 15B a graph showing the I-V characteristics and energy conversion efficiencies obtained when light was made incident from the direction of the normal to the electrode surface of the dye-sensitized solar cell shown in Fig. 14.

## DESCRIPTION OF THE PREFERRED EMBODIMENTS

The preferred embodiments of the dye-sensitized solar cells and dye-sensitized solar cell modules according to the present invention will be described below in detail with reference to the drawings. The same reference symbols will denote the same or equivalent portions and redundant description will be omitted throughout the description below.

[First Embodiment]

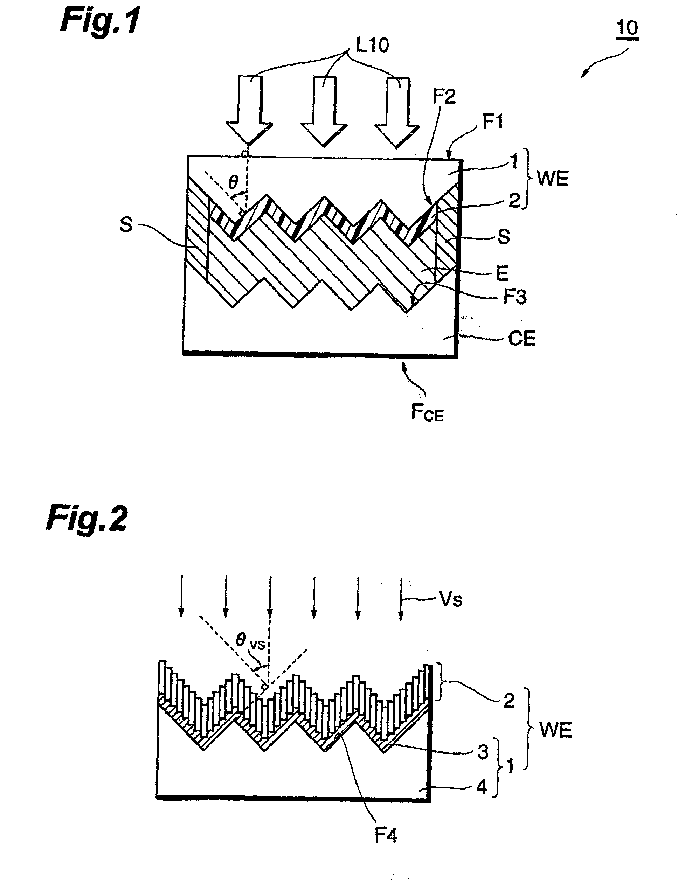

Fig. 1 is a schematic, sectional view showing the first embodiment of the dye-sensitized solar cell according to the present invention. As shown in Fig. 1, the dye-sensitized solar cell 10 of the present embodiment is mainly comprised of a photo-electrode WE having a semiconductor electrode 2 with the thickness of 5 to 30 $\mu$m and a transparent electrode 1 placed on a photoreceptive surface F2 of the semiconductor electrode 2, a counter electrode CE, and an electrolyte E filled in a space formed between the photo-electrode WE and the counter electrode CE by spacer S. In this dye-sensitized solar cell 10, light L10 passing through the transparent electrode 1 to impinge on the semiconductor electrode 2 generates electrons in the semiconductor electrode 2. Then the electrons generated in the semiconductor electrode 2 are collected to the transparent electrode 1 and taken out to the outside.

In the photo-electrode WE of the dye-sensitized solar cell 10 herein, as shown in Fig. 1, where a reference is defined along the traveling direction of the light L10 incident from the direction of the normal to the photoreceptive surface F1 of the transparent electrode 1, the semiconductor electrode 2 is formed so that the angle $\theta$ of incidence of the light L10 incident to the photoreceptive surface F2 of the semiconductor electrode from the direction of the normal to the photoreceptive surface F1 of the transparent electrode 1 falls within the range of 30 to 80°. Namely, when the semiconductor electrode 2 is viewed from the direction of the cross section thereof, the electrode layer is formed in sawtooth shape. The contact surface of the transparent electrode 1 with the semiconductor electrode 2 is also grooved in sawtooth shape fitting the shape of the semiconductor electrode 2. This makes the incident light L10 from the outside obliquely incident to the photoreceptive surface F2. Then sufficiently long optical paths can be secured in the semiconductor electrode even under the small thickness condition of the semiconductor electrode 2. For that reason, it is feasible to enhance the incident light harvest efficiency and enhance the effective energy conversion efficiency. For example, because of the incidence angle dependence of photovoltage, the energy conversion efficiency becomes approximately 1.2 times higher at $\theta = 45°$ than those of the conventional dye-sensitized solar cells having the same area. The energy conversion efficiency becomes approximately 1.5 times higher at $\theta = 70°$ than those of the conventional dye-sensitized solar cells having the same effective area.

In the dye-sensitized solar cell 10 shown in Fig. 1, the counter electrode CE is also grooved in sawtooth shape in agreement with the shape of the semiconductor electrode 2, in a surface F3 thereof in contact with the electrolyte E. In this structure, the period of the sawtooth projections and depressions is approximately several millimeters and the gap between the photo-electrode WE and the counter electrode CE is approximately 50 to 100 $\mu$m in Fig. 1. Therefore, the dye-sensitized solar cell 10 of Fig. 1 is emphatically illustrated as expanded in the vertical direction (or in the traveling direction of the light L10). In practice the surface F3 of the counter electrode CE is made in the sawtooth shape in agreement with the shape of the semiconductor electrode 2 whereby the counter electrode CE and the photo-electrode WE are arranged in parallel with each other with the layer of electrolyte E in between and thus can create a uniform, parallel electric field between them. If the shape of the surface F3 of the counter electrode CE on the electrolyte E side should be flat, the electric field would be concentrated at the projections on the photo-electrode side, so as to impede stable operation.

There are no specific restrictions on the configuration of the transparent electrode 1, and it is possible to use the transparent electrodes mounted on the ordinary dye-sensitized solar cells. For example, the transparent electrode can be one obtained by coating a semiconductor-electrode-side surface of a transparent substrate such as a glass substrate or the like (not shown) with a so-called transparent, conductive film transmitting light (cf. Fig. 2) and is, for example, a fluorine-doped $SnO_2$ coatad glass substrate, an ITO coated glass substrate, a ZnO:Al coated glass substrate, or the like. There are no specific restrictions on the semiconductor as a constitutive material of the semiconductor electrode 2, and the semiconductor can be either one selected from oxide semiconductors, sulfide semiconductors, and so on. Materials applicable as the oxide semiconductors include, for example, $TiO_2$, $ZnO$, $SnO_2$, $Nb_2O_5$, $In_2O_3$, $WO_3$, $ZrO_2$, $La_2O_3$, $Ta_2O_5$, $SrTiO_3$, $BaTiO_3$, and so on. Materials applicable as the sulfide semiconductors include, for example, CdS and others. In addition to the above-stated semiconductors, it is also possible to use Si, GaAs, and so on. There are no specific restrictions on the dye included in the semiconductor electrode 2, and the dye can be, for example, either one selected from ruthenium complexes, metal phthalocyanine, and so on.

There are no specific restrictions on the constitutive material of the counter electrode CE. For example, the counter electrode may be one wherein a thin-film metal electrode of Pt or the like is formed on a transparent, conductive film, similar to the aforementioned transparent electrode 1, and wherein the thin-film metal electrode is placed on the electrolyte E side. Further, there are no specific restrictions on the composition of the electrolyte E, either, as long as it contains the redox species for reducing the dye as having optically been excited to inject electrons into the semiconductor. A preferred electrolyte is an iodine base redox solution containing the redox species of $I^-/I_3^-$ or the like. There are no specific restrictions on the constitutive material of the spacer S, either, and it can be, for example, silica beads or the like.

A method of producing the dye-sensitized solar cell 10 of Fig. 1 will be described below. Fig. 2 shows an example of a step of producing the photo-electrode WE in the dye-sensitized solar cell 10 of Fig. 1. First, the transparent electrode 1 can be made by a known method, e.g., a method of depositing a transparent, conductive film 3 of fluorine-doped $SnO_2$ or the like, described previously, on a substrate 4 such as a glass substrate or the like by spray coating. At this time, the shape of the surface F4 of the substrate 4 on which the transparent, conductive film 3 is deposited is formed in the sawtooth cross section so as to match with the value of the angle $\theta$ of incidence of the light incident to the photoreceptive surface F2 of the complete semiconductor electrode 2. There are no specific restrictions on a method of shaping the surface of the substrate 4 in this shape, and the surface of the substrate 4 may be shaped, for example, by matching the shape of a mold, used for formation of the substrate 4 by casting, with the sawtooth section shape or by cutting one surface of the substrate formed in an approximately rectangular parallelepiped shape, into the aforementioned shape.

Then the semiconductor electrode 2 is formed by depositing a film of a semiconductor Vs of $TiO_2$ or the like on the transparent, conductive film 3 of the transparent electrode 1, as shown in Fig. 2. A method of depositing the film of the semiconductor on the transparent, conductive film 3 can be either one of known methods. For example, applicable known methods include physical evaporation methods such as electron beam evaporation, resistive heating evaporation, sputter evaporation, ionized cluster beam evaporation, and so on, and a reactive evaporation method in which a metal or the like is evaporated in reactive gas of oxygen or the like to deposit a reaction product on the transparent, conductive film 3. Further, it is also possible to use the chemical evaporation methods of CVD and the like, for example, by controlling the flow of reactive gas.

At this time, an angle $\theta vs$ of incidence of evaporative particles relative to the direction of the normal to the surface F4 of the substrate 4 on the side where the transparent, conductive film 3 is formed, is preferably in the range of $30°$ to $80°$ and is more preferably a value equal to the angle $\theta$ of incidence described previously. In this case, the electrode layer (deposited film) of the semiconductor formed on the transparent, conductive film 3 on the surface F4 is formed in the structure wherein deposited semiconductor particles form a plurality of adjacent, columnar aggregates having the slope in the range of 15 to 40° relative to the direction of the normal to the photoreceptive surface F4. Since the electrode layer of the semiconductor having this columnar structure has a larger surface area and can contain an increased amount of the dye when compared with the electrode layer of the semiconductor formed by deposition of evaporated particles from the direction of the normal to the photoreceptive surface F4, it becomes feasible to enhance the cell output and the energy conversion efficiency. If the angle θvs of incidence of the evaporative particles is less than 30°, the self-shielding effect in the evaporation becomes unnoticeable and it tends to become hard to form the definite columnar structure. When the angle θvs of incidence of the evaporative particles exceeds 80° on the other hand, the film becomes of very coarse structure and the mechanical strength could be reduced over the permissible range of practical use.

There are no specific restrictions on a method of controlling the angle θvs of incidence of the evaporative particles in the range of 30 to 80°; for example, the method may be selected from a method of preliminarily placing the substrate 4 at the predetermined angle relative to the traveling direction of the evaporative particles in an evaporation system, a method of quickly moving the substrate 4 relative to an evaporation source, and a method of providing two evaporation sources and simultaneously depositing the evaporative particles in two directions of incidence thereof to the surface F4. It is also possible to employ a method of slowly moving the substrate or the evaporation source in a direction on a plane normal to the direction of incidence of the evaporative particles during the evaporation to deposit the semiconductor particles in a spiral pattern, thereby further increasing the specific surface area thereof.

As a next step after the formation of the semiconductor deposited film serving as the semiconductor electrode 2 on the transparent, conductive film 3, the semiconductor deposited film may be subjected to a thermal treatment under a predetermined temperature condition according to necessity, to cause phase transition thereof. For example, where the semiconductor deposited film is formed in the amorphous phase state, the thermal treatment crystallizes the amorphous semiconductor film into the anatase phase. This results in forming a clear band structure by crystallization, growing crystalline particles of the semiconductor, improving bonding between crystalline particles in conjunction therewith, and so on to enhance the injection efficiency of electrons from the dye into the semiconductor or facilitate migration of electrons in the semiconductor deposited film, thereby further enhancing the energy conversion efficiency. If the aforementioned thermal treatment is carried out in a non-oxidizing atmosphere, the semiconductor deposited film can be provided with many oxygen defects, so as to increase the electric conductivity of the semiconductor deposited film, thereby further enhancing the energy conversion efficiency.

As a next step, the semiconductor deposited film is impregnated with the dye by a known method such as an immersion method or the like, thereby completing the semiconductor electrode 2. At this time, the deposited film may be impregnated with a metal such as silver or the like or a metal oxide such as alumina or the like according to necessity, in addition to the dye. After the photo-electrode WE is produced in this way, the counter electrode CE is made by a known method and the counter electrode, photo-electrode WE, and the spacer S are assembled as shown in Fig. 1. Then the interior is filled with the electrolyte E to complete the dye-sensitized solar cell 10.

[Second Embodiment]

The second embodiment of the dye-sensitized solar cell according to the present invention will be described below with reference to Fig. 3. The same reference symbols will denote the same elements as those described in the foregoing first embodiment and redundant description will be omitted. Fig. 3 is a schematic, sectional view showing the second embodiment of the dye-sensitized solar cell according to the present invention.

As shown in Fig. 3, the dye-sensitized solar cell 11 of the present embodiment is mainly comprised of the photo-electrode WE having the semiconductor electrode 2 with the thickness of 5 to 30 μm and the transparent electrode 1 placed on the photoreceptive surface F2 of the semiconductor electrode 2, the counter electrode CE, and the electrolyte E filled in the space formed between the photo-electrode WE and the counter electrode CE by the spacer S. This dye-sensitized solar cell 11 has substantially the same structure as the conventional dye-sensitized solar cells, except for an optical waveguide layer 5 (lightguide means) provided on the photoreceptive surface side of the transparent electrode 1.

The optical waveguide layer 5 has a function of changing the traveling direction of the light L11 so that the angle θ of incidence of the light L11 incident to the photoreceptive surface F2 of the semiconductor electrode 2 from the direction of the normal to the photoreceptive surface F2 of the semiconductor electrode 2 falls within the range of 30 to 80°. This optical waveguide layer 5 is comprised of a plurality of glass fibers 52 surfaces of which are plated with Ag and each of which has the diameter of about 1 mm. When each glass fiber 52 is placed on the photoreceptive surface F1 of the transparent electrode 1, it is arranged to be inclined (at an angle θ5 of inclination) relative to the direction of the normal to the photoreceptive surface F2 of the semiconductor electrode 2. At this time, the angle θ5 of inclination of each glass fiber 52 relative to the direction of the normal to the photoreceptive surface F2 is adjusted so as to agree with the angle θ of incidence of the light L11 obliquely incident to the photoreceptive surface F2 of the semiconductor electrode 2. When the light L11 coming from the direction of the normal to the photoreceptive surface F1 of the transparent electrode 1 into the optical waveguide layer 5 enters each glass fiber 52 of the optical waveguide layer 5, it changes its traveling direction to be controlled so that the angle of incidence thereof falls within the range of 30 to 80° upon incidence to the photoreceptive surface F2 of the semiconductor electrode 2. This also permits the dye-sensitized solar cell 11 to increase the incident light harvest efficiency, as in the case of the dye-sensitized solar cell 10 shown in Fig. 1, whereby the effective energy conversion efficiency can be enhanced. The glass fibers 52 constituting the optical waveguide layer 5 can be made, for example, byplating the surfaces with Ag by a known method, thereafter bundling and securing them, and obliquely cutting them crosswise so as to achieve the aforementioned inclination angle. This optical waveguide layer 5 may be one also serving as a protective glass layer provided on the photoreceptive surface F1 of the transparent electrode 1. The optical waveguide layer 5 may be doped with a rare earth element to be provided with fluorescence to ultraviolet light. Further, it is also possible to provide a separate, protective glass layer (not shown) from the optical waveguide layer 5 and in this case, the protective glass layer is not laid on the photoreceptive surface F1 of the transparent electrode 1, but laid on the optical waveguide layer 5.

[Third Embodiment]

The third embodiment of the dye-sensitized solar cell according to the present invention will be described below with reference to Fig. 4. The same reference symbols will denote the same elements as those described in the aforementioned first embodiment and redundant description will be omitted. Fig. 4 is a schematic, sectional view showing the third embodiment of the dye-sensitized solar cell according to the present invention.

As shown in Fig. 4, the dye-sensitized solar cell 12 of the present embodiment is mainly comprised of the photo-electrode WE having the semiconductor electrode 2 with the thickness of 5 to 30 μm and the transparent electrode 1 placed on the photoreceptive surface F2 of the semiconductor electrode 2, the counter electrode CE, and the electrolyte E filled in the space formed between the photo-electrode WE and the counter electrode CE by the spacer S (not shown).

This dye-sensitized solar cell 12 has substantially the same structure as the dye-sensitized solar cell 11 shown in Fig. 3, except that the optical waveguide layer 5 (lightguide means) of shape different from that of the dye-sensitized solar cell 11 shown in Fig. 3 is provided on the photoreceptive surface side of the transparent electrode 1 and that there are comb-shaped electrodes (collecting electrodes) 22 provided on the photoreceptive surface F2 side of the semiconductor electrode 2, for provision for a scaleup of unit cells of dye-sensitized solar cells to the practical use scale.

As shown in Fig. 4, the optical waveguide layer 5 of the dye-sensitized solar cell 12 is a layer wherein a plurality of grooves (of a substantially trapezoid cross section) are formed in parallel arrangement in a surface on the photoreceptive surface F1 side of the transparent electrode 1 whereby a plurality of projections 53 having a substantially triangular cross section are formed between the grooves. Each projection 53 has reflective facets F5 for changing the traveling direction of the light traveling in the optical waveguide layer 5.

The optical waveguide layer 5 is placed on the transparent electrode 1 so that the tips of the projections 53 are in contact with the photoreceptive surface F1 of the transparent electrode 1. This results in forming the photoreceptive facets F5 having predetermined inclination angles relative to the photoreceptive surface F1 of the transparent electrode 1, in the optical waveguide layer 5. Each reflective facet F5 is comprised of a reflective face R1 having the inclination angle of θ3 relative to the photoreceptive surface F1 of the transparent electrode 1 and formed in a lower local area and a reflective face R2 having the inclination angle of θ4 (> θ3) relative to the photoreceptive surface F1 of the transparent electrode 1 and formed in an upper local area.

In this dye-sensitized solar cell 12, spaces 6 of the substantially trapezoid cross section are formed between the optical waveguide layer 5 and the transparent electrode 1 because of the geometry of the optical waveguide layer 5. The spaces 6 are preferably kept in a vacuum state or filled with gas such as air or the like from a viewpoint of total reflection, but they may be filled, for example, with an organic material or the like if the refractive index thereof satisfies the condition of 86.6% or less of the refractive index of the optical waveguide layer 5.

It is noted that faces F55 of the optical waveguide layer 5 corresponding to upper base portions of the trapezoid cross section of the spaces 6 shown in Fig. 4 are provided for the reason of machining and areas of these portions are preferably as small as possible. Accordingly, it is more preferable that the spaces 6 formed between the optical waveguide layer 5 and the transparent electrode 1 be ideally of a substantially triangular cross section.

As shown in Fig. 4, the light L12 incident to the reflective facets F5 of the optical waveguide layer 5 from the direction of the normal to the photoreceptive surface F1 of the transparent electrode 1 is controlled in its traveling direction so that the angle θ of incidence of each beam to the photoreceptive surface F2 of the semiconductor electrode 2 falls within the range of 30 to 80° so as to avoid the comb-shaped electrodes 22 by making use of the difference between the inclination angles of the reflective face R1 formed in the lower local area and the reflective face R2 formed in the upper local area. Since in the dye-sensitized solar cell 12 the angles θ of incidence of the beams incident to the photoreceptive surface F2 of the semiconductor electrode 2 are not uniform, Fig. 4 shows only the incident angle θ1 as an example of the incident angles θ.

This permits the dye-sensitized solar cell 12 to avoid the degradation of the energy conversion efficiency due to the comb-shaped electrodes 22, as used to occur in the conventional dye-sensitized solar cells, even if the cell is scaled up to the practical use scale (e.g., 100 × 100 mm); therefore, it can enhance the incident light harvest efficiency and the effective energy conversion efficiency, as in the case of the dye-sensitized solar cell 10 shown in Fig. 1 and the dye-sensitized solar cell 11 shown in Fig. 3.

The refractive index of the portions of the spaces 6 shown in Fig, 4 is praferably 86.6% or less of the refractive index of the optical waveguide layer 5. The refractive index of the transparent electrode 1 is preferably larger than the refractive index of the portions of the spaces 6 shown in Fig. 4.

[Fourth Embodiment]

The fourth embodiment of the dye-sensitized solar cell according to the present invention will be described below with reference to Fig. 5. The same reference symbols will denote the same elements as those described in the aforementioned first embodiment and redundant description will be omitted. Fig. 5 is a schematic, sectional view showing the fourth embodiment of the dye-sensitized solar cell according to the present invention.

As shown in Fig. 5, the dye-sensitized solar cell 14 of the present embodiment is mainly comprised of the photo-electrode WE having the semiconductor electrode 2 with the thickness of 5 to 30 μm and the transparent electrode 1 placed on the photoreceptive surface F2 of the semiconductor electrode 2, the counter electrode CE, and the electrolyte E filled in the space formed between the photo-electrode WE and the counter electrode CE by the spacer S.

This dye-sensitized solar cell. 14 has substantially the same structure as the dye-sensitized solar cell 11 shown in Fig. 3, except that there is provided the transparent electrode 1 (lightguide means) having the structure different from that of the dye-sensitized solar cell 11 shown in Fig. 3 and that the optical waveguide layer 5 is not provided.

As shown in Fig. 5, the lightguide means of the dye-sensitized solar cell 14 is a plurality of reflective portions 120 formed in the transparent electrode 1. Each reflective portion 120 consists of reflective facets F120 for changing the traveling direction of the light L14 traveling in the transparent electrode 1. The interior of each reflective portion 120 is a space 122 of a substantially triangular cross section. This space 122 is preferably kept in a vacuum state or filled with gas such as air or the like from the viewpoint of the total reflection, but the space may be filled, for example, with an organic material or the like as long as the refractive index thereof satisfies the condition of 86.6% or less of the refractive index of the transparent electrode 1.

The reflective facets F120 of the respective reflective portions 120 are formed with a predetermined inclination (an inclination angle θ120) relative to the direction of the normal to the photoreceptive surface F2 of the semiconductor electrode 2 so that the angle θ of incidence of the light incident to the photoreceptive surface F2 of the semiconductor electrode 2 falls within the range of 30 to 80°. This also permits the dye-sensitized solar cell 14 to enhance the incident light harvest efficiency and the effective energy conversion efficiency, as in the case of the aforementioned dye-sensitized solar cell 10, dye-sensitized solar cell 11, and dye-sensitized solar cell 12. The refractive index of the portions of the spaces 122 shown in Fig. 5 needs to be 86.6% or less of the refractive index of the transparent electrode 1.

[Fifth Embodiment]

The fifth embodiment of the dye-sensitized solar cell according to the present invention will be described below with reference to Fig. 6. The same reference symbols will denote the same elements as those described in the foregoing first embodiment and redundant description will be omitted. Fig. 6 is a schematic, sectional view showing the fifth embodiment of the dye-sensitized solar cell according to the present invention.

As shown in Fig. 6, the dye-sensitized solar cell 15 of the present embodiment is mainly comprised of the photo-electrode WE having the semiconductor electrode 2 with the thickness of 5 to 30 μm and the transparent electrode 1 placed on the photoreceptive surface F2 of the semiconductor electrode 2, the counter electrode CE, and the electrolyte E filled in the space formed between the photo-electrode WE and the counter electrode CE by the spacer S.

This dye-sensitized solar cell 15 has substantially the same structure as the dye-sensitized solar cell 11 shown in Fig. 3, except that there is provided the transparent electrode 1 (lightguide means) having the structure different from that of the dye-sensitized solar cell 11 shown in Fig. 3 and that the optical waveguide layer 5 is not provided.

As shown in Fig. 6, the lightguide means of the dye-sensitized solar cell 15 is a plurality of projections 140 formed on the photoreceptive surface F1 of the transparent electrode 1. Each projection 140 has reflective facets F140 for changing the traveling direction of the light L15 incident from the direction of the normal to the photoreceptive surface F2 of the semiconductor electrode 2.

The reflective facets F140 of the respective projections 140 are formed with a predetermined inclination (an inclination angle θ140) relative to the direction of the normal to the photoreceptive surface F2 of the semiconductor electrode 2 so that the angle θ of incidence of the light incident to the photoreceptive surface F2 of the semiconductor electrode 2 falls within the range of 30 to 80°. This also permits the dye-sensitized solar cell 15 to enhance the incident light harvest efficiency and the effective energy conversion efficiency, as in the case of the foregoing dye-sensitized solar cell 10, dye-sensitized solar cell 11, dye-sensitized solar cell 12, and dye-sensitized solar cell 14. In the dye-sensitized solar cell 15, the refractive index of the transparent electrode 1 needs to be larger than that of air but smaller than that of the semiconductor electrode 2.

[Sixth Embodiment]

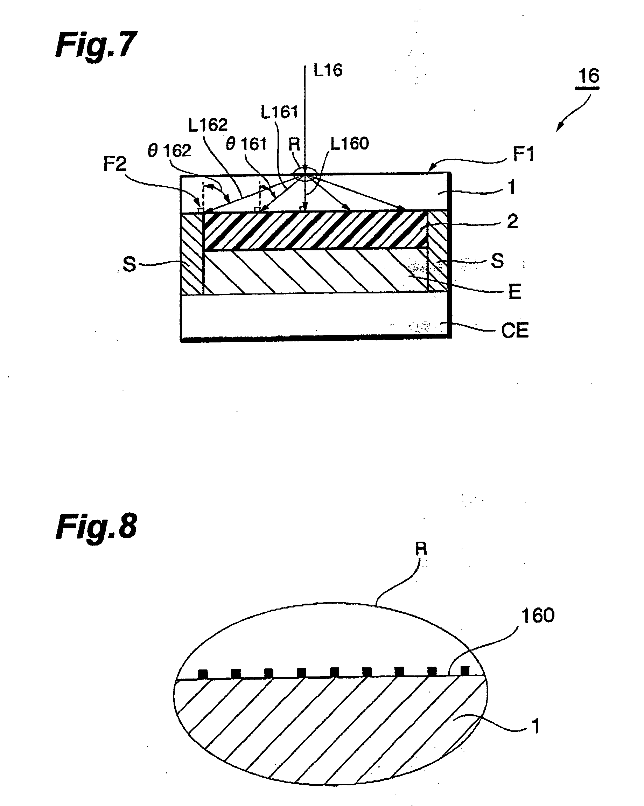

The sixth embodiment of the dye-sensitized solar cell according to the present invention will be described below with reference to Figs. 7 and 8. The same reference symbols will denote the same elements as those described in the foregoing first embodiment and redundant description will be omitted. Fig. 7 is a schematic, sectional view showing the fifth embodiment of the dye-sensitized solar cell according to the present invention. Fig. 8 is an enlarged view of a region R shown in Fig. 7.

As shown in Figs. 7 and 8, the dye-sensitized solar cell 16 of the present embodiment is mainly comprised of the photo-electrode WE having the semiconductor electrode 2 with the thickness of 5 to 30μm and the transparent electrode 1 placed on the photoreceptive surface F2 of the semiconductor electrode 2, the counter electrode CE, and the electrolyte E filled in the space formed between the photo-electrode WE and the counter electrode CE by the spacer S.

This dye-sensitized solar cell 16 has substantially the same structure as the dye-sensitized solar cell 11 shown in Fig. 3, except that there is provided the transparent electrode 1 (lightguide means) having the structure different from that of the dye-sensitized solar cell 11 shown in Fig. 3 and that the optical waveguide layer 5 is not provided.

As shown in Figs. 7 and 8, the lightguide means of the dye-sensitized solar cell 16 is a plurality of diffraction grating stripes 160 formed on the photoreceptive surface F1 of the transparent electrode 1. The diffraction grating stripes 160 are made of a transparent material having a refractive index higher than that of the transparent electrode 1 and are adapted to diffract the light L16 incident from the direction of the normal to the photoreceptive surface F2 of the semiconductor electrode 2, at predetermined angles so that angles of incidence of beams incident to the photoreceptive surface F2 of the semiconductor electrode 2 fall within the range of 30 to 80°. The transparent material having the refractive index higher than that of the transparent electrode 1 can be selected, for example, from $Ta_2O_5$ and others. As shown in Fig. 7, in the case of the dye-sensitized solar cell 16, diffracted light beams except for the zeroth-order diffracted light L160 of the light L16 diffracted by the diffraction grating stripes 160 are incident at incidence angles of 30 to 80° to the photoreceptive surface F2 of the semiconductor electrode 2. For example, Fig. 7 shows a state in which the first-order diffracted light L161 and the second-order diffracted light L162 of the light L16 incident from the direction of the normal to the photoreceptive surface F2 of the semiconductor electrode 2 is incident at the incidence angles θ161 and θ162, respectively, in the range of 30 to 80° relative to the photoreceptive surface F2 of the semiconductor electrode 2.

This also permits the dye-sensitized solar cell 16 to enhance the incident light harvest efficiency and the effective energy conversion efficiency, as in the case of the foregoing dye-sensitized solar cell 10, dye-sensitized solar cell 11, dye-sensitized solar cell 12, dye-sensitized solar cell 14, and dye-sensitized solar cell 15. In the dye-sensitized solar cell 16, the transparent material as a constitutive material of the diffraction grating stripes 160 is preferably a material having the refractive index of not less than 2.0.

[Seventh Embodiment]

The seventh embodiment of the dye-sensitized solar cell according to the present invention will be described below with reference to Fig. 9. The same reference symbols will denote the same elements as those described in the foregoing first embodiment and redundant description will be omitted. Fig. 9 is a schematic, sectional view showing the seventh embodiment of the dye-sensitized solar cell according to the present invention.

As shown in Fig. 9, the dye-sensitized solar cell 17 of the present embodiment is mainly comprised of the photo-electrode WE having the semiconductor electrode 2 with the thickness of 5 to 30 μm and the transparent electrode 1 placed on the photoreceptive surface F2 of the semiconductor electrode 2, the counter electrode CE, and the electrolyte E filled in the space formed between the photo-electrode WE and the counter electrode CE by the spacer S.

The dye-sensitized solar cell 17 has substantially the same structure as the dye-sensitized solar cell 10 shown in Fig. 1, except that there is provided the transparent electrode 1 of shape different from that of the dye-sensitized solar cell 10 shown in Fig. 1 and that there are provided the comb-shaped electrodes (collecting electrodes) 22 on the photoreceptive surface F2 side of the semiconductor electrode 2, for provision for a scaleup of unit cells of dye-sensitized solar cells to the practical use scale.

In the dye-sensitized solar cell 17, as shown in Fig. 9, the photoreceptive surface F2 of the semiconductor electrode 2 is formed so that angles θ of incidence of the light traveling in the transparent electrode 1 to enter the photoreceptive surface F2 of the semiconductor electrode 2 fall within the range of 30 to 80° and the photoreceptive surface F1 of the transparent electrode 1 is formed so that the light selectively impinges on areas without the collecting electrodes 22 on the photoreceptive surface F2 of the semiconductor electrode 2.

Namely, just as in the case of the semiconductor electrode 2 in the dye-sensitized solar cell 10 shown in Fig. 1, the semiconductor electrode 2 shown in Fig. 9 is formed so that the electrode layer is of the sawtooth shape when viewed from the sectional direction. Just as in the case of the transparent electrode 1 in the dye-sensitized solar cell 10 shown in Fig. 1, the contact surface of the transparent electrode 1 with the semiconductor electrode 2, shown in Fig. 9, is also provided with grooves in the sawtooth shape in agreement with the shape of the semiconductor electrode 2. The photoreceptive surface F1 of the transparent electrode 1 shown in Fig. 9 has a plurality of projections 170 of convex lens shape. The radius of curvature of each projection 170 is set so that the light selectively impinges on the areas without the collecting electrodes 22 on the photoreceptive surface F2 of the semiconductor electrode 2.

In the case of the dye-sensitized solar cell 17, neither of the photoreceptive surface F1 of the transparent electrode 1 and the photoreceptive surface F2 of the semiconductor electrode 2 is flat. Therefore, a virtual, flat plane is set as a virtual, photoreceptive surface FP1 inside the transparent electrode 1 or the semiconductor electrode 2. The traveling direction of the light incident from the outside is defined along the direction of the normal to the virtual, photoreceptive surface FP1, and the actual photoreceptive surface F1 of the transparent electrode 1 or photoreceptive surface F2 of the semiconductor electrode 2 is designed on the basis of the reference of the traveling direction. The present embodiment shows an example in which the virtual, photoreceptive surface FP1 is set inside the transparent electrode 1.

This also permits the dye-sensitized solar cell 17 to enhance the incident light harvest efficiency and the effective energy conversion efficiency, as in the case of the foregoing dye-sensitized solar cell 10, dye-sensitized solar cell 11, dye-sensitized solar cell 12, and dye-sensitized solar cell 14. In the dye-sensitized solar cell 17, the refractive index of the transparent electrode 1 is preferably not less than 1.4.

[Embodiment of dye-sensitized solar cell module]

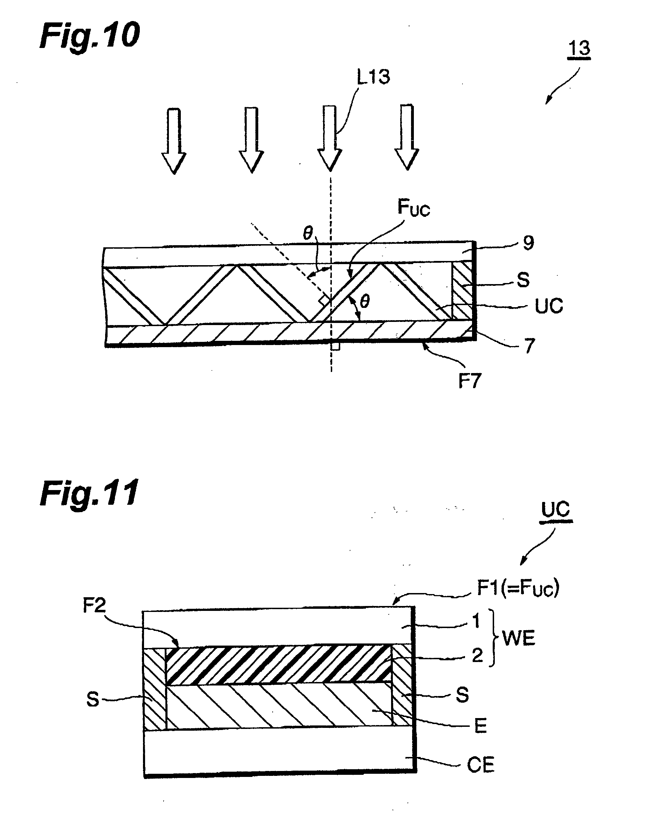

A preferred embodiment of the dye-sensitized solar cell module of the present invention will be described below with reference to Figs, 10 and 11. The same reference symbols will denote the same elements as those described in the foregoing embodiments of the dye-sensitized solar cells of the present invention and redundant description will be omitted. Fig. 10 is a schematic, sectional view showing a preferred embodiment of the dye-sensitized solar cell module according to the present invention and Fig. 11 a schematic, sectional view of one of the dye-sensitized solar cells composing the dye-sensitized solar cell module shown Fig. 10.

As shown in Fig. 10, the dye-sensitized solar cell module 13 of the present embodiment is mainly comprised of a plurality of dye-sensitized solar cells UC, a base 7 for the plurality of dye-sensitized solar cells UC to be mounted thereon, a spacer S, and a tempered glass sheet 9. As shown in Fig. 11, each dye-sensitized solar cell UC has substantially the same structure as the conventional cells and is mainly comprised of the photo-electrode WE having the semiconductor electrode 2 with the thickness of 5 to 30 μm and the transparent electrode 1 formed on the photoreceptive surface F2 of the semiconductor electrode 2, the counter electrode CE, and the electrolyte E filled in the space formed between the photo-electrode WE and the counter electrode CE by the spacer S.

Each dye-sensitized solar cell UC is mounted on the base 7 so that the angle θ of incidence of the light incident to the photoreceptive surface $F_{UC}$ of the cell from the direction of the normal to the installation surface F7 of the base 7 falls within the range of 30 to 80°. This enhances the incident light harvest efficiency of each dye-sensitized solar cell UC, whereby the effective energy conversion efficiency of the entire module can be enhanced as compared with the conventional dye-sensitized solar cell modules. Further, in this case, since light reflected on the photoreceptive surface F2 of the semiconductor electrode 2 in one dye-sensitized solar cell UC can be controlled so as to be obliquely incident to the photoreceptive surface F2 of the semiconductor electrode 2 in another dye-sensitized solar cell UC, it becomes feasible to achieve a greater antireflection effect as the entire module.

The preferred embodiments of the present invention were described above in detail, but it is noted that the present invention is by no means limited to the above embodiments.

For example, the light source was the sunlight in the case of the dye-sensitized solar cells and dye-sensitized solar cell module in the above embodiments of the present invention, but the dye-sensitized solar cells and dye-sensitized solar cell modules of the present invention are not limited to this example; for example, the light source may be ultraviolet light. In this case, for example, it is preferable to dope the semiconductor electrode or the like with a dopant to enhance the fluorescence to the ultraviolet light. For example, it is possible to employ a treatment of doping the optical waveguide layer 5 with a rare earth element in the dye-sensitized solar cell 11 of Embodiment 2.

[Examples]

The dye-sensitized solar cells and dye-sensitized solar cell modules of the present invention will be described below in further detail with examples and comparative examples, but it is noted that the present invention is by no means intended to be limited to these examples. The components of the dye-sensitized solar cells and dye-sensitized solar cell modules in the examples and comparative examples below will be described by using the same reference symbols for the same or equivalent portions as in the foregoing embodiments.

Concerning the cells having the configuration with the optical waveguide layer 5 (lightguide means) shown in Fig. 3 and the configuration of the flat photoreceptive surface F2 of the semiconductor electrode 2 among the dye-sensitized solar cells in the examples and comparative examples below, the "effective energy conversion efficiency" indicates the energy conversion efficiency per $S_0$ instead of $S_0\cos\theta$, as described previously. Accordingly, "-" is given in the column of $S_0\cos\theta$ in Table 1.

(Example 1)

The dye-sensitized solar cell on the scale of $50 \times 50$ mm with the same structure as the dye-sensitized solar cell 10 shown in Fig. 1 was fabricated as described below.

First produced as the substrate 4 of the transparent electrode 1 by casting was a glass substrate having the sawtooth surface similar to the shape of the sawtooth portion of the layer of the aforementioned semiconductor electrode 2. Then this glass substrate was spray-coated with fluorine-doped $SnO_2$ to form the transparent, conductive film 3 in the thickness of 800 nm, and then it was subjected to a thermal treatment under the condition of $500^\circ C$.

Then $TiO_2$ was deposited from the direction described in the previous description of the dye-sensitized solar cell 10, onto the sawtooth surface of the transparent electrode 1 by electron beam evaporation to form the semiconductor electrode 2 having the actual area of the photoreceptive surface F2; $140 \times 48$ mm, the layer thickness; 7 μm, the length of one side of the sawtooth portion of the layer; 5 mm, and the angle θs of inclination of the sawtooth portion; $70^\circ$ (the angle θ of incidence of light to the photoreceptive surface F2; $70^\circ$). The evaporation system used herein was the BV-6D high vacuum evaporation system available from ULVAC JAPAN, Ltd. The evaporation source was $TiO_2$ (rutile, purity; 99.99%) available from Kojundo Chemical Laboratory Co., Ltd. The deposition conditions were the effective size of the evaporation surface; $47.9 \times 48.0$ mm, the evaporation speed; 1.4nm/s, the substrate temperature; $205^\circ C$, the degree of vacuum in the chamber of the evaporation system before the start of evaporation; $1 \times 10^{-3}$ Pa, and the degree of vacuum in the chamber of the evaporation system during the evaporation; $1 \times 10^{-3}$ Pa.

After introducing oxygen up to 1 Pa, the temperature of the sample holder of the evaporation system was increased at the increase rate of $10^\circ C$/min from $60^\circ C$ to $400^\circ C$ and the sample holder was retained at this temperature for 30 minutes to anneal the semiconductor electrode 2 of $TiO_2$ deposited on the transparent electrode 1. This annealing treatment crystallized the amorphous phase of $TiO_2$ deposited on the transparent electrode 1, into the anatase phase. It was preliminarily confirmed by X-ray diffraction that the amorphous phase of deposited $TiO_2$ was crystallized into the anatase phase by the foregoing annealing treatment.

Then the dye was made to adsorb on the surface of the semiconductor electrode 2 of produced $TiO_2$ in the following manner. First, a ruthenium complex [cis-Di (thiocyanato) -N, N'-bis(2, 2'-bipyridyl-4, 4' dicarboxylic acid) -ruthenium(II)] was dissolved in the concentration of $2.85 \times 10^{-4}$ mol/L into a solvent of absolute ethanol dehydrated with magnesium ethoxide, thereby preparing a ruthenium complex solution. Then the semiconductor electrode 2 was immersed in this solution for twenty four hours. This operation made the semiconductor electrode 2 adsorb the ruthenium complex in about $1.0 \times 10^{-7}$ mol/cm$^2$, which would become the dye. Then, in order to increase the open-circuit voltage Voc, the semiconductor electrode 2 after the adsorption of the ruthenium complex was immersed in an acetonitrile solution for fifteen minutes, and thereafter dried in a nitrogen stream kept at $25^\circ C$, thus completing the photo-electrode WE.

On the other hand, the counter electrode CE was an electrode obtained by depositing a thin film of Pt (thickness; 3 nm) on a fluorine-doped $SnO_2$ coated glass substrate having the shape and size similar to those of the transparent electrode 1. The electrolyte E was an iodine base redox solution prepared in such a way that tetra-n-propylammonium iodide; 3.13 g and iodine; 0.18 g were dissolved in a mixed solution of ethylene carbonate; 21.14 g and acetonitrile; 4.0 mL. Further prepared was the spacer S (trade name: "Himilan") available from DuPont Co. in the shape according to the size of the semiconductor electrode 2, and, as shown in Fig. 1, the photo-electrode WE and the counter electrode CE were opposed through the spacer S. The interior of the space was filled with the foregoing electrolyte E to complete the dye-sensitized solar cell.

(Example 2)

The substantially same dye-sensitized solar cell as in Example 1 was produced by the substantially same process as in Example 1, except that the semiconductor electrode 2 was prepared with the sawtooth portion at the inclination angle $\theta s$; 45° (the angle $\theta$ of incidence of light to the photoreceptive surface F2; 45°).

(Example 3)

The substantially same dye-sensitized solar cell as in Example 1 was produced by the substantially same process as in Example 1, except that the semiconductor electrode 2 was prepared with the sawtooth portion at the inclination angle $\theta s$; 30° (the angle $\theta$ of incidence of light to the photoreceptive surface F2; 30°).

(Comparative Example 1)

The substantially same dye-sensitized solar cell as in Example 1 was produced by the substantially same process as in Example 1, except that the shape of the photo-electrode WE and the counter electrode CE was the same as that in the conventional dye-sensitized solar cell shown in Fig. 11 (the angle of incidence of light to the photoreceptive surface F2; 0°).

(Comparative Example 2)

The substantially same dye-sensitized solar cell as in Example 1 was produced by the substantially same process as in Example 1, except that the semiconductor electrode 2 was prepared with the sawtooth portion at the inclination angle $\theta s$; 20° (the angle $\theta$ of incidence of light to the photoreceptive surface F2; 20°).

(Example 4)

Produced was the dye-sensitized solar cell (the actual area $S_0$ of the photoreceptive surface F2; 48 × 48 mm and the layer thickness; 7 $\mu$m) having the structure shown in Fig. 3 and the size similar to that in Example 1. This dye-sensitized solar cell was produced in the structure in which among the components except for the optical waveguide layer 5 (the inclination angle $\theta 5$ relative to the photoreceptive surface F1 of the transparent electrode 1; 70° and the angle $\theta$ of incidence of light to the photoreceptive surface F2; 70°) provided on the photoreceptive surface F1 of the transparent electrode 1, the shape of the photo-electrode WE and the counter electrode CE was similar to that in the conventional dye-sensitized solar cell shown in Fig. 11, and by the substantially same process as in Example 1.
The glass fibers constituting the optical waveguide layer 5 were glass fibers having the diameter of 1 mm. The surfaces of the glass fibers were plated with Ag, they were bundled and secured, and thereafter they were obliquely cut crosswise in accordance with the aforementioned inclination angle $\theta$ into the length of 5 mm. The glass fibers prepared in this way were mounted on the photoreceptive surface of the transparent electrode 1 with a glass adhesive.

(Example 5)

The substantially same dye-sensitized solar cell as in Example 4 was produced by the substantially same process as in Example 4, except that the optical waveguide layer 5 was prepared with the inclination angle $\theta 5$ to the photoreceptive surface F1 of the transparent electrode 1; 45° and the angle $\theta$ of incidence of light to the photoreceptive surface F2; 45°.

(Example 6)

The substantially same dye-sensitized solar cell as in Example 4 was produced by the substantially same process as in Example 4, except that the optical waveguide layer 5 was prepared with the inclination angle $\theta 5$ to the photoreceptive surface F1 of the transparent electrode 1; 30° and the angle $\theta$ of incidence of light to the photoreceptive surface F2; 30°.

(Example 7)

The dye-sensitized solar cell having the substantially same structure as in Example 4 was produced by the substantially same process as in Example 4, except that the optical waveguide layer 5 was doped with 0.2 mol% of a rare earth element (samarium) to enhance the fluorescence to ultraviolet light.

(Comparative Example 3)

The dye-sensitized solar cell having the substantially same structure as in Comparative Example 1 was produced by the substantially same process as in Example 1, except that the rare earth element (samarium) was added 0.2 mol% near the photoreceptive surface F1 of the transparent electrode 1 in the dye-sensitized solar cell of Comparative Example 1.

(Example 8)

Produced was the dye-sensitized solar cell having the substantially same structure as in Example 4, except that the semiconductor electrode having the thickness of 20 $\mu$m and the actual area $S_0$ of the photoreceptive surface; 73.47 mm$^2$ was formed on the transparent electrode 1 by screen-printing commercially available $TiO_2$ particles (average particle size; 30nm) and a paste prepared for screen printing with a screen printer and thereafter performing the thermal treatment under the temperature condition of 400°C for thirty minutes.

(Example 9)

Produced was the dye-sensitized solar cell having the substantially same structure as in Example 5, except that the semiconductor electrode having the thickness of 20 $\mu$m and the actual area $S_0$ of the photoreceptive surface; 73.47 mm$^2$ was formed on the transparent electrode 1 by screen-printing the commercially available $TiO_2$ particles (average particle size; 30 nm) and the paste prepared for screen printing with the screen printer and thereafter performing the thermal treatment under the temperature condition of 400°C for thirty minutes.

(Example 10)

Produced was the dye-sensitized solar cell having the substantially same structure as in Example 6, except that the semiconductor electrode having the thickness of 20 $\mu$m and the actual area $S_0$ of the photoreceptive surface; 73.47 mm$^2$ was formed on the transparent electrode 1 by screen-printing the commercially available $TiO_2$ particles (average particle size; 30 nm) and the paste prepared for screen printing with the screen printer and thereafter performing the thermal treatment under the temperature condition of 400°C for thirty minutes.

(Comparative Example 4)

The substantially same dye-sensitized solar cell as in Example 8 was produced by the substantially same process as in Example 8, except that the optical waveguide layer 5 was prepared with the inclination angle θ5 to the photoreceptive surface F1 of the transparent electrode 1; 0° and the angle θ of incidence of light to the photoreceptive surface F2; 0°.

(Comparative Example 5)

The substantially same dye-sensitized solar cell as in Example 9 was produced by the substantially same process as in Example 9, except that the optical waveguide layer 5 was prepared with the inclination angle θ5 to the photoreceptive surface F1 of the transparent electrode 1; 20° and the angle θ of incidence of light to the photoreceptive surface F2; 20°.

(Comparative Example 6)

The substantially same dye-sensitized solar cell as in Example 10 was produced by the substantially same process as in Example 10, except that the optical waveguide layer 5 was prepared with the inclination angle θ5 to the photoreceptive surface F1 of the transparent electrode 1; 85° and the angle θ of incidence of light to the photoreceptive surface F2; 85°.

(Example 11)

The dye-sensitized solar cell having the substantially same structure as in Example 4 was produced by the substantially same process as in Example 4, except that the semiconductor electrode having the thickness of 10 $\mu$m and the actual area $S_0$ of the photoreceptive surface; 71.1 mm$^2$ was formed on the transparent electrode 1 by tape casting of two types of $TiO_2$ particles (average particle sizes; 200 nm and 25 nm) commercially available.

The foregoing tape casting of $TiO_2$ particles was conducted according to the following procedure. Namely, powder of $TiO_2$ particles was first kneaded together with deionized water and a chelating agent in an alumina mortar. Then deionized water and a surfactant were added into the alumina mortar and the mixture was agitated and mixed therein to prepare slurry containing the $TiO_2$ particles. Then Scotch tape was placed at intervals of 10mm on the transparent electrode 1. Then the slurry was dropped into troughs formed between the tape strips. Then the dropped slurry was spread over the entire regions of the troughs formed between the tape strips with a glass bar. Thereafter, the slurry was dried at room temperature for about one day and then the Scotch tape strips were removed from on the transparent electrode 1. Then the slurry was thermally treated in an air stream under the condition of 450°C for thirty minutes.

(Example 12)

The dye-sensitized solar cell having the substantially same structure as in Example 5 was produced by the substantially same process as in Example 5, except that the semiconductor electrode having the thickness of 10 μm and the actual area $S_0$ of the photoreceptive surface; 71.1 mm$^2$ was formed on the transparent electrode 1 by the tape casting of two types of $TiO_2$ particles (average particle sizes; 220 nm and 30 nm) synthesized by the autoclave method, in much the same manner as in Example 11.

(Example 13)

The dye-sensitized solar cell having the substantially same structure as in Example 6 was produced by the substantially same process as in Example 6, except that the semiconductor electrode having the thickness of 10 μm and the actual area So of the photoreceptive surface; 71.1 mm$^2$ was formed on the transparent electrode 1 by the tape casting of two types of $TiO_2$ particles (average particle sizes; 220 nm and 30 nm) synthesized by the autoclave method, in much the same manner as in Example 11.

(Comparative Example 7)

The substantially same dye-sensitized solar cell as in Example 11 was produced by the substantially same process as in Example 11, except that the optical waveguide layer 5 was prepared with the inclination angle θ5 to the photoreceptive surface F1 of the transparent electrode 1; 0° and the angle θ of incidence of light to the photoreceptive surface F2; 0°.

(Comparative Example 8)

The substantially same dye-sensitized solar cell as in Example 12 was produced by the substantially same process as in Example 12, except that the optical waveguide layer 5 was prepared with the inclination angle θ5 to the photoreceptive surface F1 of the transparent electrode 1; 20° and the angle θ of incidence of light to the photoreceptive surface F2; 20°.

(Comparative Example 9)

The substantially same dye-sensitized solar cell as in Example 13 was produced by the substantially same process as in Example 13, except that the optical waveguide layer 5 was prepared with the inclination angle θ5 to the photoreceptive surface F1 of the transparent electrode 1; 85° and the angle θ of incidence of light to the photoreceptive surface F2; 85°.

(Example 14)

The dye-sensitized solar cell module having the structure shown in Fig. 10 was fabricated. This dye-sensitized solar cell module was constructed of two hundred and ninety dye-sensitized solar cells UC (the actual area of the photoreceptive surface F2; 48 × 48 mm, the layer thickness; 7 μm, the angle of incidence of light to each dye-sensitized solar cell UC from the direction of the normal to the installation surface F7 of the base 7; 70°) each having the structure shown in Fig. 11 and the size similar to that of the dye-sensitized solar cell in Example 1.

The dye-sensitized solar cells UC were arranged in an array of 29 units horizontal and 10 units depthwise on the front view of Fig. 10, on the base 7. The Teflon spacer S was placed around the external edge of the base 7 and the tempered glass sheet 9 available from Asahi Glass Co., Ltd., covering all the dye-sensitized solar cells UC, was placed on the photoreceptive surface side of the dye-sensitized solar cells UC placed on the base 7.

(Example 15)

The dye-sensitized solar cell module was fabricated in the substantially same structure as in Example 14, except that the angle of incidence of the light incident to each dye-sensitized solar cell UC from the direction of the normal to the installation surface F7 of the base 7 was 45°.

(Example 16)

The dye-sensitized solar cell module was fabricated in the substantially same structure as in Example 14, except that the angle of incidence of the light incident to each dye-sensitized solar cell UC from the direction of the normal to the installation surface F7 of the base 7 was 30°.

(Comparative Example 10)

The dye-sensitized solar cell module was fabricated in the substantially same structure as in Example 14, i. e., in the conventional structure except that the angle of incidence of the light incident to each dye-sensitized solar cell UC from the direction of the normal to the installation surface F7 of the base 7 was 0°.

(Comparative Example 11)

The dye-sensitized solar cell module was fabricated in the substantially same structure as in Example 14, except that the angle of incidence of the light incident to each dye-sensitized solar cell UC from the direction of the normal to the installation surface F7 of the base 7 was 20°.

(Comparative Example 12)

The dye-sensitized solar cell module was fabricated in the substantially same structure as in Example 14, except that the angle of incidence of the light incident to each dye-sensitized solar cell UC from the direction of the normal to the installation surface F7 of the base 7 was 85°.

[Tests of cell characteristics]

The effective energy conversion efficiencies $\eta$ were measured with the dye-sensitized solar cells and dye-sensitized solar cell modules of Examples 1 to 16 and Comparative Examples 1 to 12. As cell characteristic tests, the I-V properties were measured with an I-V tester under irradiation of 1000 W/m$^2$ artificial sunlight, using a large-scale solar simulator calibrated with a solar simulator (WXS-85 available from WACOM ELECTRIC CO., LTD), to determine the open-circuit voltage, short-circuit current, and effective energy conversion efficiency. The results of the measurement are presented in Table 1.

**[TABLE 1]**

As apparent from the results presented in Table 1, the effective energy conversion efficiencies $\eta$ of the dye-sensitized solar cells and dye-sensitized solar cell modules of Example 1 to 16 were higher than those $\eta$ of the dye-sensitized solar cells and dye-sensitized solar cell modules of respectively corresponding Comparative Examples 1 to 12. For example, the energy conversion efficiency of the dye-sensitized solar cell of Example 1 was 27% higher and the energy conversion efficiency of the dye-sensitized solar cell of Example 5 was 21% higher than that of the dye-sensitized solar cell of Comparative Example 1.

Further, the effective energy conversion efficiency $\eta$ of the dye-sensitized solar cell module of Example 15 was 21% higher and that of the dye-sensitized solar cell module of Example 14 was 29% higher than that $\eta$ of the dye-sensitized solar cell module of Comparative Example 10.

As apparent from these results, it was verified that the dye-sensitized solar cells and dye-sensitized solar cell modules of the present invention were significantly valid for enhancing the energy conversion efficiencies of solar cells. Absolute values of energy conversion efficiencies of dye-sensitized solar cells vary depending upon the composition of the electrolyte and the type of the dye, independently of the configurations of the present invention, but in such cases the present invention is also able to always enhance the currently existing energy conversion efficiencies in the respective cases. Namely, the dye-sensitized solar cells and dye-sensitized solar cell modules of the present invention are able to achieve the universal enhancement effect of energy conversion efficiency.

(Example 17)

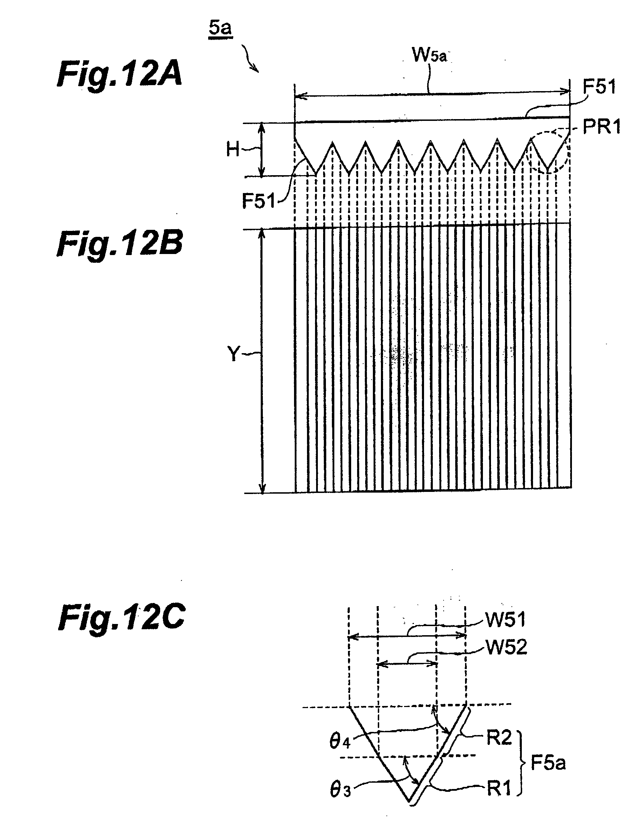

The 100×100mm-scale dye-sensitized solar cell (the actual area $S_0$ of the photoreceptive surface F2; 96 × 96 mm and the thickness; 22 mm) was fabricated in the substantially same structure as the dye-sensitized solar cell 12 shown in Fig. 4, except for provision of the optical waveguide layer 5a in the shape shown in Fig. 12 (a) to (c), according to the substantially same procedure as in Example 1.

Fig. 12 (a) is another sectional view of the optical waveguide layer 5a provided in this dye-sensitized solar cell, Fig. 12 (b) a front view of the optical waveguide layer 5a shown in Fig. 12 (a), on the photo-electrode WE side, and Fig. 12 (c) an enlarged view of a partial region PR1 of the optical waveguide layer 5a shown in Fig. 12 (a).

In the optical waveguide layer 5a (width W5a; 100 mm, depth Y; 100 mm, thickness; 4 mm) shown in Fig. 12 (a) to (c), reflective facets F5a were formed at predetermined angles of inclination relative to the photoreceptive surface F1 of the transparent electrode 1 as described previously, in which the angle θ3 of inclination relative to the photoreceptive surface F1 of the transparent electrode 1 was 59° ± 0.5° and in which the angle θ4 of inclination relative to the photoreceptive surface F1 of the transparent electrode 1 and the reflective face R1 formed in the lower local area was 63° ± 0.5°.

This optical waveguide layer 5a was designed so that there was no shielding loss of light quantity due to the comb-shaped electrodes 22 in the case of the configuration wherein the thickness of the glass (transparent electrode 1) forming the dye-sensitized solar cell was 1.1 mm, the refractive index thereof was 1.52, the width of the comb-shaped electrodes 22 was 0.5 mm, and the distance between the comb-shaped electrodes 22 was 12 mm.

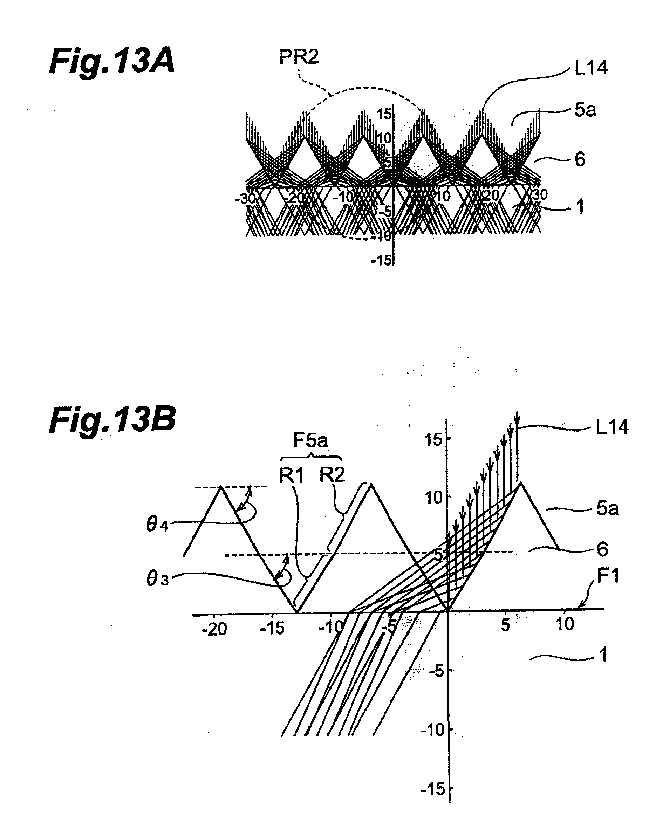

Fig. 13 shows the result of ray tracing where normal incident light was made incident to the optical waveguide layer 5a, wherein Fig. 13 (a) is a sectional view of the optical waveguide layer 5a. Fig. 13 (b) is an enlarged view of a partial region PR2 of the coating layer shown in (a). The effective energy conversion efficiency of this dye-sensitized solar cell was determined in much the same manner as in the cell characteristic tests described previously, and the result was 6.2%.

(Comparative Example 13)

The conventional dye-sensitized solar cell was fabricated in the substantially same structure as the dye-sensitized solar cell of Example 17, except that the optical waveguide layer 5a shown in Fig. 12 was not provided. Then the energy conversion efficiency of the solar cell was determined, and the result was 5.1%.

As described above, the dye-sensitized solar cells and dye-sensitized solar cell modules according to the present invention are able surely to secure the sufficient utilization factors of incident light even with use of the thin semiconductor electrode and readily to reduce the deterioration of utilization factor of incident light due to decrease of the photoreceptive area satisfactorily even if they are scaled up or modularized. Accordingly, the present invention is able to provide the dye-sensitized solar cells and dye-sensitized solar cell modules having the excellent energy conversion efficiencies comparable to the amorphous silicon solar cells andbeing capable of generating electric power on a stable basis.

TABLE 1

| | CELL STRUCTURE | ANGLE OF INCIDENCE $\theta/°$ | SEMICONDUCTOR ELECTRODE | | | EFFECTIVE ENERGY CONVERSION EFFICIENCY $\eta$ /% |
| | | | THICKNESS OF ELECTRODE /$\mu$m | ACTUAL AREA OF PHOTORECEPTIVE SURFACE $S_0$ /mm$^2$ | PROJECTED AREA OF PHOTORECEPTIVE SURFACE $S_0 \cos \theta$ /mm$^2$ | |
|---|---|---|---|---|---|---|
| EXAMPLE 1 | FIG. 1 | 7 0 | 7.0 | 6722.4 | 2299.2 | 6.1 |
| EXAMPLE 2 | FIG. 1 | 4 5 | 7.0 | 3360 | 2376 | 5.6 |
| EXAYPLE 3 | FIG. 1 | 3 0 | 7.0 | 2443.3 | 2116 | 4.9 |
| EXAMPLE 4 | FIG.3 | 7 0 | 7.0 | 2304 | - | 6.2 |
| EXAMPLE 5 | FIG. 3 | 4 5 | 7.0 | 2304 | - | 5.8 |
| EXAMPLE 6 | FIG. 3 | 3 0 | 7.0 | 2304 | - | 5.1 |
| EXAMPLE 7 | FIC. 3 | 7 0 | 7.0 | 2304 | - | 6.3 |
| EXAMPLE 8 | FIG. 3 | 7 0 | 20.0 | 73.47 | - | 8.8 |
| EXAMPLE 9 | FIG. 3 | 4 5 | 20.0 | 73.47 | - | 8.2 |
| EXAMPLE 10 | FIG. 3 | 3 0 | 20.0 | 73.47 | - | 7.1 |
| EXAMPLE 11 | FIG. 3 | 7 0 | 10.0 | 71.1 | - | 8.5 |
| EXAMPLE 12. | FIG. 3 | 4 5 | 10.0 | 71.1 | - | 7.8 |
| EXAMPLE 13 | FIG. 3 | 3 0 | 10.0 | 71.1 | - | 6.8 |
| EXAMPLE 14 | FIG. 10 | 7 0 | 7.0 | 668160.0 | 228524.2 | 4.4 |
| EXAMPLE 15 | FIG. 10 | 4 5 | 7.0 | 332560.0 | 228084.4 | 4.1 |
| EXAMPLE 16 | FIG. 10 | 3 0 | 7.0 | 253440.0 | 219485.5 | 3.4 |
| COMPARATIVE EXAMPLE 1 | FIG. 11 | 0 | 7 0 | 2304 | 2304 | 4.8 |
| COMPARATIVE EXAMPLE 2 | FIG. 1 | 2 0 | 7.0 | 2400.7 | 2256 | 4.7 |
| COMPARATIVE EXAMPLE 3 | FIG. 3 | 2 0 | 7.0 | 2304 | - | 4.9 |

TABLE 1 (continued)

| | | | | SEMICONDUCTOR ELECTRODE | | |
|---|---|---|---|---|---|---|
| | CELL STRUCTURE | ANGLE OF INCIDENCE $\theta/°$ | THICKNESS OF ELECTRODE $/\mu m$ | ACTUAL AREA OF PHOTORECEPTIVE SURFACE $S_0$ $/mm^2$ | PROJECTED AREA OF PHOTORECEPTIVE SURFACE $S_0 \cos \theta$ $/mm^2$ | EFFECTIVE ENERGY CONVERSION EFFICIENCY $\eta$ /% |
| COMPARATIVE EXAMPLE 4 | FIG. 3 | 0 | 20.0 | 73.47 | - | 6.8 |
| COMPARATIVE EXAMPLE 5 | FIG. 3 | 2 0 | 20.0 | 73.47 | - | 6.7 |
| COMPARATIVE EXAMPLE 6 | FIG. 3 | 8 5 | 20.0 | 73.47 | - | 2.1 |
| COMPARATIVE EXAMPLE 7 | FIG. 3 | 0 | 10.0 | 71.1 | - | 6.5 |
| COMPARATIVE EXAMPLE 8 | FIG. 3 | 2 0 | 10.0 | 71.1 | - | 6.4 |
| COMPARATIVE EXAMPLE 9 | FIG. 3 | 8 5 | 10.0 | 71.1 | - | 2.0 |
| COMPARATIVE EXAMPLE 10 | FIG. 10 | 0 | 7.0 | 230400.0 | 230400.0 | 3.4 |
| COMPARATIVE EXAMPLE 11 | FIG. 10 | 2 0 | 7.0 | 230400.0 | 230400.0 | 3.2 |
| COMPARATIVE EXAMPLE 12 | FIG. 10 | 8 5 | 7.0 | 230400.0 | 230400.0 | 0.1 |

**Claims**

1. A dye-sensitized solar cell which comprises a photo-electrode having a semiconductor electrode and a transparent electrode placed on a photoreceptive surface of the semiconductor electrode, and a counter electrode and in which said semiconductor electrode is opposed through an electrolyte to said counter electrode,

    wherein said photoreceptive surface of said semiconductor electrode is formed so that an angle of incidence of light incident to said photoreceptive surface of said semiconductor electrode from a direction of a normal to a photoreceptive surface of said transparent electrode falls within a range of 30 to 80°.

2. A dye-sensitized solar cell which comprises a photo-electrode having a semiconductor electrode and a transparent electrode placed on a photoreceptive surface of the semiconductor electrode, and a counter electrode and in which said semiconductor electrode is opposed through an electrolyte to said counter electrode,

    wherein said transparent electrode is provided with lightguide means for changing a traveling direction of light incident from the outside to a photoreceptive surface of said transparent electrode so that an angle of incidence of the light traveling in said transparent electrode to enter said photoreceptive surface of said semiconductor electrode falls within a range of 30 to 80°.

3. The dye-sensitized solar cell according to Claim 2, wherein said lightguide means is an optical waveguide layer formed on said photoreceptive surface of said transparent electrode and comprised of a plurality of glass fibers,

    wherein each said glass fiber is placed with a predetermined inclination relative to a direction of a normal to said photoreceptive surface of said semiconductor electrode so that the angle of incidence of the light incident to said photoreceptive surface of said semiconductor electrode falls within the range of 30 to 80°.

4. The dye-sensitized solar cell according to Claim 2, wherein said lightguide means is an optical waveguide layer formed on said photoreceptive surface of said transparent electrode,

    wherein a plurality of projections with reflective facets for changing the traveling direction of the light traveling in the optical waveguide layer are formed in a lower region of said optical waveguide layer in contact with said photoreceptive surface of said transparent electrode,

    wherein each said reflective facet is formed with a predetermined inclination relative to said photoreceptive surface of said transparent electrode so that the angle of incidence of the light incident to said photoreceptive surface of said semiconductor electrode falls within the range of 30 to 80°.

5. The dye-sensitized solar cell according to Claim 4, wherein a plurality of collecting electrodes are further provided on said photoreceptive surface of said semiconductor electrode,

    wherein each said reflective facet is formed with the predetermined inclination relative to said photoreceptive surface of said transparent electrode so that the angle of incidence of the light incident to said photoreceptive surface of said semiconductor electrode falls within the range of 30 to 80° and so that said light selectively impinges on areas without said collecting electrodes on said photoreceptive surface of said semiconductor electrode.

6. The dye-sensitized solar cell according to Claim 2, wherein said lightguide means is a plurality of reflective portions with reflective facets formed in said transparent electrode and adapted to change the traveling direction of the light traveling in said transparent electrode,

    wherein each said reflective facet is formed with a predetermined inclination relative to a direction of a normal to said photoreceptive surface of said semiconductor electrode so that the angle of incidence of the light incident to said photoreceptive surface of said semiconductor electrode falls within the range of 30 to 80°.

7. The dye-sensitized solar cell according to Claim 2, wherein said lightguide means is a plurality of projections with reflective facets formed on saidphotoreceptive surface of said transparent electrode and adapted to change the traveling direction of the light incident from a direction of a normal to the photoreceptive surface of said semiconductor electrode,

    wherein each said reflective facet is formed with a predetermined inclination relative to the direction of the normal to said photoreceptive surface of said semiconductor electrode so that the angle of incidence of the light incident to said photoreceptive surface of said semiconductor electrode falls within the range of 30 to 80°.

8. The dye-sensitized solar cell according to Claim 2, wherein said lightguide means is a plurality of diffraction grating stripes formed on the photoreceptive surface of said transparent electrode and made of a transparent material having a refractive index higher than that of said transparent electrode,

    wherein said diffraction grating stripes diffract the light incident from a direction of a normal to said photoreceptive surface of said semiconductor electrode, into predetermined angles so that angles of incidence of the light incident to said photoreceptive surface of said semiconductor electrode fall within the range of 30 to 80°.

9. A dye-sensitized solar cell which comprises a photo-electrode having a semiconductor electrode and a transparent electrode placed on a photoreceptive surface of the semiconductor electrode, and a counter electrode and in which said semiconductor electrode is opposed through an electrolyte to said counter electrode,
   wherein a plurality of collecting electrodes are provided on said photoreceptive surface of said semiconductor electrode,
   wherein said photoreceptive surface of said semiconductor electrode is formed so that an angle of incidence of light traveling in said transparent electrode to enter said photoreceptive surface of said semiconductor electrode falls within a range of 30 to 80°, and
   wherein a photoreceptive surface of said transparent electrode is formed so that said light selectively impinges on areas without said collecting electrodes on said photoreceptive surface of said semiconductor electrode.

10. A dye-sensitized solar cell module comprising a plurality of dye-sensitized solar cells placed on a base, each said dye-sensitized solar cell comprising a photo-electrode having a semiconductor electrode and a transparent electrode placed on a photoreceptive surface of the semiconductor electrode, and a counter electrode and in each said dye-sensitized solar cell said semiconductor electrode being opposed through an electrolyte to said counter electrode,
   wherein each said dye-sensitized solar cell is placed so that an angle of incidence of light incident to each said dye-sensitized solar cell from a direction of a normal to an installation surface of said base falls within a range of 30 to 80°.

## Fig.1

## Fig.2

**Fig.3**

# Fig.4

**Fig.5**

**Fig.6**

**Fig.7**

**Fig.8**

# Fig.9

EP 1 237 166 A2

## *Fig.10*

13

L13

F_UC

θ

θ

9

S

UC

7

F7

## *Fig.11*

UC

F2

F1(=F_UC)

1 } WE

2 }

S

E

CE

S

**Fig.12A**

**Fig.12B**

**Fig.12C**

**Fig.13A**

PR2

L14

5a

6

1

15
10
5
-30    -20    -10         10    20    30
-5
-10
-15

**Fig.13B**

F5a

R1  R2

L14

5a

6

F1

$\theta_4$

$\theta_3$

1

15

10

5

-20    -15    -10    -5         5    10

-5

-10

-15

*Fig.14*

## Fig.15A

## Fig.15B